(19) Europäisches Patentamt
European Patent Office
Office européen des brevets

(11) **EP 4 687 298 A1**

(12) **EUROPÄISCHE PATENTANMELDUNG**

(43) Veröffentlichungstag:
**04.02.2026 Patentblatt 2026/06**

(21) Anmeldenummer: **24192351.5**

(22) Anmeldetag: **01.08.2024**

(51) Internationale Patentklassifikation (IPC):
**H03M 1/12** (2006.01)    **H04L 27/22** (2006.01)
**H03M 1/64** (2006.01)

(52) Gemeinsame Patentklassifikation (CPC):
**H04L 27/22; H03M 1/64**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(71) Anmelder: **Siemens Aktiengesellschaft 80333 München (DE)**

(72) Erfinder:
• **Helmdach, Alexander
  09130 Chemnitz (DE)**
• **Prochaska, Dirk
  09127 Chemnitz (DE)**
• **Raab, Oliver
  94496 Ortenburg (DE)**
• **Weikert, Robert
  92342 Burggriesbach (DE)**

(74) Vertreter: **Siemens Patent Attorneys
Postfach 22 16 34
80506 München (DE)**

(54) **VERFAHREN ZUM ABGLEICHEN EINES PHASENMODULATIONSWANDLERS UND PHASENMODULATIONSWANDLER**

(57)     Die Erfindung betrifft ein Verfahren zum Abgleichen eines Phasenmodulationswandlers (P), wobei der Phasenmodulationswandler (1) aufweist:
- einen Amplitudenmodulator (2) mit Trägerunterdrückung,
- einen Addierer (7),
- einen Begrenzer (11), und
- eine Demodulationseinrichtung (16), der das von dem Begrenzer (11) ausgegebene Signal (Sig$_{BA}$) zugeführt und darin demoduliert werden kann, wobei im Rahmen der Demodulation ein Vergleich des von dem Begrenzer ausgegebenen Signals (Sig$_{BA}$) mit einem Referenzsignal (Sig$_{RF}$) erfolgen kann,

- einen dem Addierer (7) vorgeschalteten Abgleichschalter (S), der zwischen einer Regelstellung, in welcher der Addierer (7) über den Abgleichschalter (S) mit dem Eingang des Phasenmodulationswandlers (1) verbunden sind, und wenigstens einer Abgleichstellung, in welcher die unterbrochen ist, betätigt werden kann,
wobei das Verfahren umfasst, dass in einem Schritt S1 in einer Abgleichstellung des Abgleichschalters (S) die Phasenlage des Referenzsignals bevorzugt dynamisch geändert und eine Phasenlage des Referenzsignals gefunden wird, bei der ein Ausgangssignal der Demodulationseinrichtung einen abgeglichenen Wert einnimmt.

FIG 1

**Beschreibung**

Die Erfindung betrifft ein Verfahren zum Abgleichen eines Phasenmodulationswandlers und einen Phasenmodulationswandler.

Ein Analog-Digital-Wandler dient dazu, eine analoge Eingangsgröße in ein digitales Signal zu konvertieren. Konventionelle Analog-Digital-Wandler sind z.B. der SAR-Wandler (Sukzessiv-Approximations-Wandler) und der Sigma-Delta-Wandler. Beide Wandlertypen sind mit Nachteilen verbunden, welche aus Gleichspannungsfehlern des analogen Eingangssignals resultieren.

Die EP 3 624 334 A1 offenbart eine weiterentwickelte Vorrichtung zur Wandlung eines analogen Eingangssignals in ein digitales Ausgangssignal. Konkret handelt es sich um einen Analog-Digital-Wandler (ADC-Wandler), der auf dem Unterschied der Phasenlage eines zur zu messenden Eingangsspannung modulierten Signals im Vergleich zu einem Referenzsignal basiert. Der aus der EP 3 624 334 A1 vorbekannte Analog-Digital-Wandler kann auch als Phasenmodulationswandler bezeichnet werden.

Der Phasenmodulationswandler gemäß der 3 624 334 A1 umfasst einen Amplitudenmodulator mit Trägerunterdrückung zur Bereitstellung eines trägerlosen amplitudenmodulierten Signals. Der Amplitudenmodulator weist ein Signaleingang auf, an dem ein analoges, zu wandelndes Eingangssignal zugeführt werden kann. Es ist ferner ein Addierer vorhanden, dem das von dem Amplitudenmodulator ausgegebene trägerlose amplitudenmodulierte Signal zugeführt wird und der dazu eingerichtet ist, zu diesem ein um 90° verschobenes Trägersignal zu addieren und ein phasenmoduliertes Signal bereitzustellen. Weiterhin ist ein Begrenzer vorhanden, dem das von dem Addierer ausgegebene, phasenmodulierte Signal zugeführt wird und der dazu ausgebildet ist, eine Störamplitudenmodulation in dem phasenmodulierten Signal zu unterdrücken.

Das resultierende Ausgangssignal des Begrenzers weist eine Amplitude auf, welche aus 0 oder 1 besteht. Man kann auch sagen, es liegt ein in der Amplitude digitales Signal vor. Die Länge dieser Impulse ist in Abhängigkeit der gewählten Trägerfrequenz wertkontinuierlich.

Die Information steckt in der Länge der Rechteckpulse. Das Ausgangssignal des Begrenzers trägt die Modulation in zeitlich unterschiedlichen Nulldurchgängen im Vergleich zu dem 90°-Trägersignal. In diesem Zusammenhang sei auch auf die Figuren der EP 3 624 334 A1, insbesondere die darin enthaltenen Figuren 5 bis 8 nebst zugehöriger Beschreibung verwiesen, welche das Prinzip näher erläutern.

Das vom Begrenzer ausgegebene Signal, das vorliegend auch kurz als begrenztes Signal bezeichnet wird, kann anschließend abgetastet werden, wobei die Abtastung ausreichend schnell erfolgen sollte, um die Nulldurchgänge zu erfassen (Abtasttheorem).

Für Analog-Digital-Wandler hat es sich bewährt, insbesondere vor der Inbetriebnahme einen Abgleich durchzuführen. Dies etwa, um PCB-Laufzeitdifferenzen zu kompensieren. Die Abkürzung PCB steht dabei für Printed Circuit Board bzw. Leiterplatte.

Bei konventionellen Analog-Digital-Wandlern, wie sie eingangs genannt sind, erfolgt häufig ein Abgleich des Offsets im Werk. Hierbei wird die Eingangsspannung z.B. auf 0V gelegt und der zugehörige Digitalwert für spätere rechnerische Korrekturen abgespeichert. Der Anmelderin ist auch bekannt, dass ein Abgleich zusätzlich im Betrieb erfolgen kann. Hierfür ist dann entweder eine kurzfristige Verdrahtungsänderung auf der Anlage des Benutzers nötig oder es werden entsprechende Schaltelemente in der analogen Schaltung vorgesehen. Technisch kann dies konventionell zum Beispiel mittels Relais SSR's oder Transistoren, die durch eine schon auf der potentialgetrennten Seite vorhandenen Logik angesteuert werden, gelöst werden. Diese Art von Abgleich muss jedoch immer rückwirkungsfrei auf den angeschlossenen Sensor sein, von dem das Signal stammt, welches zu wandeln ist. Ein Kurzschluss eines aktiven Sensors durch die Messelektronik sollte vermieden werden. Dies führt zu weiterem Schaltungsaufwand.

Der Anmelderin weiterhin bekannt ist, dass mit konventionellen Analog-Digital-Wandlern bidirektionale Analogeingänge realisiert werden (+/-10V, +-20mA). Im Gegensatz zu unidirektionalen Eingängen ist hier jedoch erheblich mehr Schaltungsaufwand erforderlich da die ersten Verstärkungsstufen in der Signalaufbereitung eine negative Eingangsspannung messen können müssen. Damit ist es häufig nötig, eine positive und negative Versorgungsspannung für diese Verstärkerstufen bereitzustellen. Einhergehend sind z.B. zusätzliche Wicklungen in den Transformatoren, der Schaltregler, zusätzliche Linearregler sowie zusätzliche passive Komponenten zur Filterung. Als Alternative zum Aufbau der negativen Versorgungsspannung gibt es nach Kenntnis der Anmelderin Konzepte, bei denen die Eingangsspannung auf die halbe Referenzspannung gelegt wird. Anschließend wird das Signal als fully oder pseudo differenzielles Signal am konventionellen ADC eingelesen. Bei dieser Lösung sind zusätzliche genaue Widerstände in der Operationsverstärkerschaltung nötig. Weiterhin wird durch ein Missmatch der Widerstände die Common Mode Rejection des Operationsverstärkers negativ beeinträchtigt.

Diese Problemstellungen haben beim Prinzip des Phasenmodulationswandlers keine Bedeutung, da hier die Eingangsspannung in eine entsprechende modulierte Spannung umgewandelt wird. Es hat sich jedoch gezeigt, dass u.a. aufgrund von Laufzeiten auf der PCB, mit anderen Worten Leiterplatte, auf welcher der Phasenmodulationswandler bzw. Komponenten dieses realisiert sind, einschließlich analoger Filterstufen, mitunter nicht ganz genau ein Nullpunkt definiert werden kann.

Es ist eine Aufgabe der vorliegenden Erfindung, ein Verfahren anzugeben, mittels dem ein Abgleich eines Phasenmodulationswandlers durchgeführt werden kann. Darüber hinaus ist eine Aufgabe der Erfindung, einen Phasenmodulationswandler anzugeben, mit dem sich ein solches Verfahren durchführen lässt.

Die erstgenannte Aufgabe wird gelöst durch ein Verfahren zum Abgleichen eines Phasenmodulationswandlers, wobei der Phasenmodulationswandler aufweist:

- einen Amplitudenmodulator mit Trägerunterdrückung, dem ein zu wandelndes Eingangssignal eingangsseitig zugeführt werden kann, um ein trägerloses amplitudenmoduliertes Signal zu erhalten,
- einen Addierer, um zu dem trägerlosen amplitudenmodulierten Signal ein phasenverschobenes, bevorzugt sinusförmiges Addierer-Trägersignal zu addieren und ein phasenmoduliertes Signal zu erhalten,
- einen Begrenzer, dem das phasenmodulierte Signal zugeführt werden und mit dem eine Störamplitudenmodulation in dem phasenmodulierten Signal unterdrückt werden kann, und
- eine Demodulationseinrichtung, der das von dem Begrenzer ausgegebene Signal zugeführt und darin demoduliert werden kann, wobei im Rahmen der Demodulation ein Vergleich des von dem Begrenzer ausgegebenen Signals mit einem Referenzsignal erfolgen kann, und wobei in der Demodulationseinrichtung das Addierer-Trägersignal erzeugt werden kann,
- einen dem Addierer vorgeschalteten, insbesondere zwischen dem Amplitudenmodulator und dem Addierer angeordneten Abgleichschalter, der zwischen einer Regelstellung, in welcher der Addierer über den Abgleichschalter mit einem Eingang des Phasenmodulationswandlers verbunden ist, und wenigstens einer Abgleichstellung, in welcher die Verbindung zwischen dem Addierer und dem Eingang des Phasenmodulationswandlers unterbrochen und bevorzugt eine andere Verbindung, insbesondere eine Verbindung des Addierers mit der Erde oder Masse, hergestellt ist, betätigt werden kann,

wobei das Verfahren umfasst, dass in einem Schritt S1 in einer Abgleichstellung des Abgleichschalters, insbesondere wenn eine Verbindung mit der Erde oder Masse besteht, die Phasenlage des Referenzsignals bevorzugt dynamisch geändert und eine Phasenlage des Referenzsignals gefunden wird, bei der ein Ausgangssignal der Demodulationseinrichtung einen abgeglichenen Wert einnimmt, der den unter dieser Phasenverschiebung maximal erreichbaren Wert darstellt oder sich höchstens um eine vorgegebene Maximalabweichung von dem unter dieser Phasenverschiebung maximal erreichbaren Wert unterscheidet.

Die zweitgenannte Aufgabe wird gelöst durch einen Phasenmodulationswandler, umfassend

- einen Amplitudenmodulator mit Trägerunterdrückung, dem ein zu wandelndes Eingangssignal eingangsseitig zugeführt werden kann, um ein trägerloses amplitudenmoduliertes Signal zu erhalten,
- einen Addierer, um zu dem trägerlosen amplitudenmodulierten Signal ein phasenverschobenes, bevorzugt sinusförmiges Addierer-Trägersignal zu addieren und ein phasenmoduliertes Signal zu erhalten,
- einen Begrenzer, dem das phasenmodulierte Signal zugeführt werden und mit dem eine Störamplitudenmodulation in dem phasenmodulierten Signal unterdrückt werden kann, und
- eine Demodulationseinrichtung, der das von dem Begrenzer ausgegebene Signal zugeführt und darin demoduliert werden kann, wobei im Rahmen der Demodulation ein Vergleich des von dem Begrenzer ausgegebenen Signals mit einem Referenzsignal erfolgen kann, und wobei in der Demodulationseinrichtung das Addierer-Trägersignal erzeugt werden kann, und
- einen dem Addierer vorgeschalteten, insbesondere zwischen dem Amplitudenmodulator und dem Addierer angeordneten Abgleichschalter, der zwischen einer Regelstellung, in welcher der Addierer über den Abgleichschalter mit einem Eingang des Phasenmodulationswandlers verbunden sind, und wenigstens einer Abgleichstellung, in welcher die Verbindung zwischen dem Addierer und dem Eingang des Phasenmodulationswandlers unterbrochen und bevorzugt eine andere Verbindung, insbesondere ein Verbindung des Addierers mit der Erde oder Masse, hergestellt ist, betätigt werden kann,

wobei der Phasenmodulationswandler ausgebildet und/oder eingerichtet, um für einen Abgleich die Phasenlage des Referenzsignals bevorzugt dynamisch zu ändern und eine Phasenlage des Referenzsignals zu finden, bei der ein Ausgangssignal der Demodulationseinrichtung einen abgeglichenen Wert einnimmt, der den unter dieser Phasenverschiebung maximal erreichbaren Wert darstellt oder sich höchstens um eine vorgegebene Maximalabweichung von dem unter dieser Phasenverschiebung maximal erreichbaren Wert unterscheidet.

Gegenstand der Erfindung ist mit anderen Worten auch ein Phasenmodulationswandler, der zur Durchführung des erfindungsgemäßen Verfahrens ausgebildet und/oder eingerichtet ist. Der erfindungsgemäße Phasenmodulationswandler ist insbesondere ausgebildet und/oder eingerichtet, um den Schritt S1 des Verfahrens durchzuführen.

Die vorliegende Erfindung sieht mit anderen Worten einen insbesondere dynamischen Offset-Abgleich für einen Phasenmodulationswandler vor. Es hat sich gezeigt, dass bei einem Phasenmodulationswandler ein Abgleich durch gezieltes, aktives Anpassen der Phasenlage des Referenzsignals möglich ist, welches für die Demodulation zum Einsatz kommt. Es kann somit ein Signal genutzt werden, welches für den Betrieb des Phasenmodulationswandlers generiert wird und ohnehin zur Verfügung steht. Auf die erfindungsgemäße Weise kann mit vertretbarem Aufwand ein zuverlässiger Abgleich eines als Phasenmodulationswandler ausgebildeten Analog-Digital-Wandlers erfolgen, u.a. Fertigungs- und Bauteiltoleranzen ausgeglichen werden.

Der erfindungsgemäße Phasenmodulationswandler, mittels dem das Verfahren durchgeführt werden kann, zeichnet sich dabei durch einen vergleichsweise einfachen Aufbau aus.

Dass die Phasenlage des Referenzsignals dynamisch geändert wird bedeutet insbesondere, dass eine mehrfache, wiederholte Änderung erfolgt. Die Änderung erfolgt zweckmäßiger Weise so lange, bis ein gewünschter Wert erreicht wird. Bevorzugt derart, dass ein Maximum erreicht bzw. angenähert wird. Beispielsweise kann eine erste Änderung in einer Richtung erfolgen und beobachtet bzw. ermittelt werden, ob sich der Ausgangswert des Demodulators erhöht. Ist dem so, kann in diese Richtung weitergegangen werden, andernfalls wird in die andere Richtung geändert. Dies kann z.B. mittels wenigstens einer Logik realisiert werden.

Erfolgt ein Abgleich auf einen Wert, der sich höchstens um eine vorgegebene Maximalabweichung von dem unter dieser Phasenverschiebung maximal erreichbaren Wert unterscheidet, gilt in bevorzugter Ausgestaltung, dass die Maximalabweichung 3%, insbesondere 2%, bevorzugt 1% des unter dieser Phasenverschiebung maximal erreichbaren Wertes beträgt.

Durch den zu diesem Zwecke vorgesehenen Abgleichschalter kann die Spannung auf der Demodulator-, insbesondere Logikseite, kurzgeschlossen werden. Es kann die Eingangsspannung in den Addierer auf Null gesetzt werden, um anschließend den Abgleich durchzuführen.

Um die Eingangsspannung auf 0V zu setzten, bieten sich speziell SSRs (Solid State Relais) oder auch einfache MEMS-Schalter an, da damit weiterhin der Vorteil des Phasenmodulationswandlers einer möglichen reinen passiven Schaltung auf der Prozessseite genutzt werden kann. Der Abgleichschalter kann insbesondere als Wechsel-Schalter ausgebildet sein. Er kann wenigstens ein mechanisches Relais und/oder wenigstens ein Solid-State-Relais und/oder wenigstens ein Reed-Relais und/oder wenigstens einen MEMS-Schalter umfassen oder dadurch gegeben sein. Die Abkürzung MEMS steht hierbei in bekannter Weise für "Micro-Electro-Mechanical Systems".

Der Abgleichschalter ist dem Addierer vorgeschaltet. Er befindet sich in Eingangsrichtung des Phasenmodulationswandlers vor dem Addierer. Der Abgleichschalter kann sich prinzipiell an beliebiger Stelle auf dem Signalpfad des Phasenmodulationswandlers vor dem Addierer befinden. Er befindet sich mit anderen Worten zwischen dem Eingang des Phasenmodulationswandlers und dem Addierer. Er kann, muss jedoch nicht die letzte Komponente vor dem Addierer sein. Es können auch eine oder mehrere weitere Komponenten zwischen dem Addierer und Abgleichschalter liegen, zum Beispiel wenigstens ein Filter und/oder wenigstens eine galvanische Trennung.

Der Abgleichschalter kann vor oder hinter dem Amplitudenmodulator, mit anderen Worten zwischen dem Eingang des Phasenmodulationswandlers und dem Amplitudenmodulator oder zwischen dem Amplitudenmodulator und dem Addierer liegen. Die zweite Variante hat sich dabei als besonders vorteilhaft erwiesen.

Der Abgleichschalter ist dabei ausgebildet, um den Signalpfad, bei dem es sich um einen differentiellen Signalpfad handeln kann, zu unterbrechen und eine andere Verbindung herzustellen. In der Regelstellung stellt der Abgleichschalter eine Verbindung des Addierers mit dem Eingang des Phasenmodulationswand - ggf. über weitere Komponenten - her bzw. bereit.

Bevorzugt gilt, dass der Abgleichschalter in der Abgleichstellung die Verbindung wenigstens eines Eingangs des Addierers, der in der Regelstellung mit wenigstens einem Ausgang des Amplitudenmodulators - entweder direkt oder auch über eine oder mehrere weitere Komponenten - gegeben ist, auftrennt, mit anderen Worten unterbricht. Der Abgleichschalter verbindet in der Abgleichstellung insbesondere wenigstens einen auf dem Signalpfad liegenden Eingang des Addierers mit der Erde bzw. Masse, wobei auch diese Verbindung natürlich über weitere Komponenten bestehen kann, etwa eine Verbindung wenigstens eines Eingangs des Addierers mit der Erde/Masse über den Amplitudenmodulator und/oder wenigstens einen Filter und/oder wenigstens eine galvanische Trennung oder dergleichen.

Für den Fall, dass der Addierer für eine differentielle Signalübertragung zwei Eingänge aufweist, gilt zweckmäßiger Weise, dass der Abgleichschalter in der Abgleichstellung jeden der beiden für die differentielle Signalübertragung vorhandenen Eingänge - statt mit dem Eingang des Phasenmodulationswandlers bzw. mit dem Amplitudenmodulator - mit der Erde bzw. Masse verbindet. Weiter bevorzugt kann bei differentieller Signalübertragung gelten, dass in der Regelstellung des Abgleichschalters beide Signaleingänge des Addierers mit jeweils einem von zwei differentiellen Ausgängen des Amplitudenmodulators - entweder direkt oder auch über eine oder mehrere weitere Komponenten - verbunden sind.

Der Abgleich des Phasenmodulationswandlers kann komplett rückwirkungsfrei auf ein externes Signal als neue Nullphasenlage erfolgen. Dies kann vorteilhaft genutzt werden, wenn externe analoge Signale z.B. nur auf eine größere Änderung oder einen Schwellwert überwacht werden müssen.

Auch kann die Eigenschaft des Phasenmodulationswandlers, dass die Eingangsspannung über eine arctan-Funktion auf eine Ausgangsspannung abgebildet wird, noch besser ausgenutzt werden. Geringe Änderung der Phasendifferenz um die Nulllage bringen einen, im Vergleich zur gleichen Änderung am Rand des Eingangsspannungsbereiches, größeren Signalhub. Das bedeutet, dass das Signal-Rausch-Verhältnis für alle Eingangsspannungen in erster Näherung konstant bleibt, was bei konventionellen Analog-Digital-Wandlern nicht der Fall ist.

Der erfindungsgemäße Abgleich des Phasenmodulationswandlers kann beispielsweise wenigstens ein Mal vor erster Inbetriebnahme durch den Benutzer, etwa ab Werk, erfolgen. Alternativ oder zusätzlich ist es auch möglich, dass der erfindungsgemäße Abgleich wenigstens ein Mal nach der ersten Inbetriebnahme durchgeführt wird, etwa, wenn der Phasenmodulationswandler im Feld einer industriellen Anlage bzw. Maschine installiert ist und z.B. zur Wandlung eines Sensorsignals zum Einsatz kommt.

Als ganz besonders geeignet hat sich erweisen, wenn der Phasenmodulationswandler wenigstens eine galvanische Trennung umfasst, die zweckmäßiger Weise dem Abgleichschalter vorgeschaltet ist. Vorgeschaltet bedeutet dabei, dass sie in Eingangsrichtung des Phasenmodulationswandlers vor dem Abgleichschalter liegt. Es kann insbesondere wenigstens eine galvanische Trennung zwischen dem Amplitudenmodulator und dem Addierer vorgesehen sein. Eine galvanische Trennung umfasst bevorzugt wenigstens ein Paar von Koppelkondensatoren. Dies insbesondere für den Fall einer differentiellen Signalübertragung und in diesem Falle jeweils einen Koppelkondensator für einen der beiden differentiellen Signalpfade.

Durch den Aufbau bedingt ist es dann möglich, besonders einfach, insbesondere ohne die Notwendigkeit von potenitalgetrennten Schaltelementen, direkt die aus dem Amplituden-, insbesondere Schaltermodulator über Koppelkondensator(en) ankommende amplitudenmodulierte Spannung auf der Logikseite kurzzuschließen.

Zweckmäßiger Weise gilt, dass insbesondere ab dem Ausgang des Amplitudenmodulators und/oder bis zum Ausgang des Begrenzers bzw. Eingangs der Demodulationseinrichtung eine differentielle Signalübertragung erfolgt. Der erfindungsgemäße Phasenmodulationswandler ist in Weiterbildung entsprechend ausgebildet. Man kann auch sagen, dass dann zumindest beginnend vom Ausgang des Amplitutenmodulators und insbesondere zumindest bis hin zum Ausgang des Begrenzers bzw. bis hin zur Demodulationseinrichtung eine differentielle Signalübertragung aufgebaut wird.

Der Addierer kann wenigstens einen Operationsverstärker umfassen oder dadurch gegeben sein. Es kann sich insbesondere um wenigstens einen volldifferentiellen Operationsverstärker handeln.

Bevorzugt wird mittels der Demodulationseinrichtung eine Flächenüberlappung zwischen dem begrenzten Signal und dem Referenzsignal berechnet, dies insbesondere über mehrere Perioden. Die Demodulationseinrichtung kann entsprechend ausgebildet und/oder eingerichtet sein.

Bei dem Ausgangssignal der Demodulationseinrichtung, dessen Verhalten unter der Variation der Phasenlage des Referenzsignals in Abgleichstellung des Abgleichschalters betrachtet wird, handelt es sich insbesondere um den bzw. die Digitalwerte, welche der Phasenmodulationswandler ausgibt.

Der Phasenmodulationswandler bzw. dessen Demodulationseinrichtung umfasst in vorteilhafter Ausgestaltung wenigstens einen FPGA (Field Programmable Gate Array) und/oder wenigsten einen ASIC (Application-Specific Integrated Circuit). Dann kann insbesondere gelten, dass in dem FPGA bzw. in der FPGA-Auswertung bzw. in dem ASIC bzw. der ASIC-Auswertung die Möglichkeit geschaffen wird bzw. ist, die Phasenlage des Referenzsignals bevorzugt dynamisch zu verschieben.

Der erfindungsgemäße Phasenmodulationswandler kann wenigstens eine Logik aufweisen, die ausgebildet und/oder eingerichtet ist, um die Phasenlage des Referenzsignals bevorzugt dynamisch zu ändern und die Phasenlage des Referenzsignals zu finden, bei der das Ausgangssignal der Demodulationseinrichtung den abgeglichenen Wert einnimmt, der den unter dieser Phasenverschiebung maximal erreichbaren Wert darstellt oder sich höchstens um die vorgegebene Maximalabweichung von dem unter dieser Phasenverschiebung maximal erreichbaren Wert unterscheidet. Eine solche Logik, die vorliegend auch als Referenz-Logik bezeichnet wird, kann Bestandteil der Demodulationseinrichtung sein, etwa auf einem FPGA dieser vorgesehen bzw. implementiert sein.

Auch die Betätigung des Abgleichschalters in die jeweils gewünschte Stellung kann mittels wenigstens einer Logik realisiert sein bzw. werden.

Als vorteilhaft hat sich ferner erwiesen, wenn das Referenzsignal aus dem Ausgangssignal eines insbesondere spannungsgesteuerten Oszillators erzeugt wird, der Bestandteil einer Phasenregelschleife ist, und die dynamische Änderung der Phasenlage des Referenzsignals erzielt wird, indem die Phasenlage eines Rückkoppelsignals für den Oszillator, welches ausgangsseitig des Oszillators abgegriffen und dem Oszillator insbesondere eingangsseitig wieder zugeführt wird, dynamisch geändert wird, insbesondere um Schritte von weniger als 40°, bevorzugt um Schritte von weniger als 20°, besonders bevorzugt um Schritte von weniger als 10°.

Es kann gelten, dass der Oszillator wenigstens einen phasenvariablen Abgriff und zweckmäßiger Weise wenigstens einen phasenstarren Abgriff aufweist, wobei der wenigstens eine phasenvariable Abgriff es ermöglicht, die 360° Phasenlage des Oszillators in n Schritte zu unterteilen, wobei n eine natürlich Zahl größer oder gleich 30, insbesondere größer oder gleich 40, bevorzugt größer oder gleich 50, besonders bevorzugt größer oder gleich 100 ist. Dann kann weiterhin gelten, dass das Referenzsignal aus dem wenigstens einen phasenvariablen Abgriff erhalten wird. Der phasenvariablen Abgriff kann dann das Referenzsignal ausgeben bzw. von diesem kann das Referenzsignal abgegriffen bzw. genommen werden. Die Phasenlage des Referenzsignal kann dann durch entsprechende Ansteuerung bzw. Einstellung des phasenvariablen Abgriffs insbesondere dynamisch und um Schritte von 360°/n geändert werden, bis der gewünschte Wert vorliegt.

Auch ist es möglich, dass der phasenvariable Abgriff mit dem Rückkoppelpfad des Oszillators verbunden ist, so dass ein von dem phasenvariable Abgriff stammendes Signal dem Oszillator als Rückkoppelsignal insbesondere eingangsseitig wieder zugeführt werden kann, und die Phasenlage des von dem phasenvariable stammenden Signals dynamisch um Schritte von 360°/n geändert wird.

Man kann auch sagen, ein phasenvariabler Abgriff kann entweder für den Rückkoppelpfad des Oszillator oder direkt, sozusagen im "Vorwärtszweig" genutzt werden, um die Phasenlagenänderung des Referenzsignals zu realisieren.

Der erfindungsgemäße Phasenmodulationswandler, insbesondere dessen Demodulationseinrichtung, kann ein Referenzsignal-Erzeugungsmodul zur Erzeugung des Referenzsignals aufweisen, was sich als geeignete konstruktive Umsetzung erwiesen hat. Das Referenzsignal-Erzeugungsmodul kann dann den insbesondere spannungsgesteuerten Oszillator umfassen, der Bestandteil einer Phasenregelschleife ist, und das Referenzsignal kann aus dem Ausgangssignal des Oszillators des Referenzsignal-Erzeugungsmoduls erzeugt werden. Der Oszillator kann wenigstens einen phasenvariablen Abgriff und wenigstens einen phasenstarren Abgriff aufweisen, wobei der wenigstens eine phasenvariable Abgriff es ermöglicht, die 360° Phasenlage des Oszillators in n Schritte zu unterteilen. Der wenigstens eine phasenvariable Abgriff kann entsprechend ausgebildet sein.

Das Referenzsignal kann direkt aus dem phasenvariablen Abgriff erhältlich sein.

Der phasenvariable Abgriff kann aber auch mit dem Rückkoppelpfad des Oszillators verbunden sein, so dass ein von dem phasenvariable Abgriff stammendes Signal dem Oszillator als Rückkoppelsignal insbesondere eingangsseitig wieder zugeführt werden kann, und der Phasenmodulationswandler, beispielsweise eine Referenz-Logik dieses, ist insbesondere ausgebildet und/oder eingerichtet, um die Phasenlage des von dem phasenvariable Abgriff des Oszillators des Referenzsignal-Erzeugungsmoduls stammenden Signals bevorzugt dynamisch um Schritte von 360°/n zu ändern.

Eine Realisierung der Phasenänderung kann mit anderen Worten beispielsweise erzielt werden, indem ein Oszillator mit phasenvariablem Abgriff zum Einsatz kommt, welcher eine Unterteilung der Phasenlage in feine Schritte ermöglicht. Rein beispielhaft sei in diesem Zusammenhang verwiesen auf FPGAs (Field Programmable Gate Arrays) des Herstellers Xilinx bzw. AMD, die es in einer Ausführung mit einem Mixed-Mode Clock-Manager-Modul, kurz MMCM-Modul, gibt, das eine solche feine Unterteilung der Phase an einem phasenvariablen Abgriff bietet. Die entsprechende Funktion wird auch als "finePS" bezeichnet, was für "fine phase shift" steht. Diese Option kann im Rahmen der vorliegenden Erfindung zum Einsatz kommen, um eine insbesondere dynamische, schrittweise Änderung der Phasenlage insbesondere bis zur Findung eines Maximums, zu erzielen. Dies insbesondere, indem der phasenvariable Abgriff für das bzw. als Rückkoppelsignal für den Oszillator genutzt wird. Der Anmelderin sind zum Beispiel FPGA-Modelle von XILINX bzw. AMD bekannt, die an einem entsprechenden phasenvariablen Abgriff eine Unterteilung der Phase ("finePS") in 56 Schritte, mit anderen Worten in Schritte von 360°/n mit n = 56, ermöglicht, was sich im Rahmen der vorliegenden Erfindung für geeignet erwiesen hat. Es sei jedoch betont, dass natürlich auch eine feinere oder gröbere Unterteilung möglich ist und genutzt werden kann. Weiter beispielhaft seien FPGAs von Lattice Semiconductor genannt, insbesondere der Serie EPS, ECP5, EPC5-5G, die ebenfalls eine feine Unterteilung der Phase und zwar mit bis zu 300 Schritten ermöglichen.

Gemäß einer weiteren besonders bevorzugten Ausführungsform der Erfindung ist ferner vorgesehen, dass dem Amplitudenmodulator für die Trägerunterdrückung ein mittels der Demodulationseinrichtung erzeugtes Trägersignal zugeführt wird, Modulator-Trägersignal, insbesondere an einem weiteren Eingang des Amplitudenmodulators, der auch als Träger-Eingang bezeichnet werden kann, und dass in einem Schritt S2 in der Abgleichstellung des Abgleichschalters, insbesondere wenn eine Verbindung mit der Erde oder Masse besteht, die Phasenlage des Modulator-Trägersignals und/oder des Addierer-Trägersignals bevorzugt dynamisch geändert und dabei eine Phasenlage des Modulator-Trägersignals und/oder des Addierer-Trägersignals gefunden wird, bei der ein Ausgangssignal der Demodulationseinrichtung einen abgeglichenen Wert einnimmt, der den unter dieser Phasenverschiebung - also der Phasenverschiebung des Modulator-Trägersignals und/oder des Addierer-Trägersignals - maximal erreichbaren Wert darstellt oder sich höchstens um eine vorgegebene Maximalabweichung von dem unter dieser Phasenverschiebung maximal erreichbaren Wert unterscheidet.

Erfolgt ein Abgleich auf einen Wert, der sich höchstens um eine vorgegebene Maximalabweichung von dem unter dieser Phasenverschiebung maximal erreichbaren Wert unterscheidet, gilt in bevorzugter Ausgestaltung, dass die Maximalabweichung 3%, insbesondere 2%, bevorzugt 1% des unter dieser Phasenverschiebung maximal erreichbaren Wertes beträgt.

In einem Schritt S2 kann mit anderen Worten neben dem reinen Abgleich durch die Verschiebung des Referenzsignals ein weiterer, zusätzlicher Abgleich erfolgen, um die Lagebeziehung zwischen Addierer- und Modulator-Trägersignal sicherzustellen. Diese beiden Trägersignale zeichnen sich idealerweise durch eine Phasenverschiebung von 90° zueinander aus. Beispielsweise kann das Addierer-Trägersignal sinusförmig und das Modulator-Trägersignal cosinusförmig mit 90° Phasenversatz sein. In Schritt S2 wird aktiv der Phasenversatz zwischen dem Modulator-Trägersignal und dem Addierer-Trägersignal variiert, bevorzugt derart, bis das unter dieser Art der Variation erhältliche Maximum erhalten wird. Das Maximum ergibt sich, wenn Modulator-Trägersignal und Addierer-Trägersignal um 90° zueinander versetzt sind. Eine Abweichung von den 90° resultiert in einen unterschiedlich großen Phasenhub in die verschiedenen Richtungen, was zu ungenauen bzw. fehlerhaften Ergebnissen führen kann. Auch durch den Abgleich über die Phasenlage von Modulator-Trägersignal und Addierer-Trägersignal können u.a. Fertigungs- und Bauteiltoleranzen ausgeglichen werden.

Der Schritt S2 wird zweckmäßiger Weise unter bzw. mit derjenigen Phasenlage des Referenzsignals durchgeführt, die in Schritt S1 zuvor gefunden wurde.

Es sei angemerkt, dass in Schritt S2 unter Verschiebung der Phasenlage von Modulator-Trägersignal und/oder Addierer-Trägersignal in der Regel ein noch höherer Wert als Maximalwert gefunden werden kann, als der Maximalwert in Schritt S1. Dies ist aber nicht zwingend der Fall. Noch größer würde der Wert beispielsweise nicht, wenn zum Startpunkt von Schritt S2 (zufällig) schon ein Phasenversatz von genau 90° zwischen Modulator-Trägersignal und/oder Addierer-Trägersignal vorliegen würde.

Es versteht sich ferner, dass es zum Erhalt einer gewünschten Phasenlage von Modulator-Trägersignal und Addierer-Trägersignal ausreicht, wenn entweder (nur) die Phasenlage des Modulator-Trägersignals oder (nur) die Phasenlage des Addierer-Trägersignals verändert und das resultierende Ausgangssignals beobachtet wird, insbesondere, um das Maximum oder einen dem Maximum ausreichend nahen Wert zu erhalten.

Der erfindungsgemäße Phasenmodulationswandler ist in vorteilhafter Weiterbildung ausgebildet und/oder eingerichtet, um den Schritt S2 durchzuführen.

Bei dem erfindungsgemäßen Phasenmodulator kann entsprechend vorgesehen sein, dass der Amplitudenmodulator mit der Demodulationseinrichtung verbunden ist und dem Amplitudenmodulator für die Trägerunterdrückung ein mittels der Demodulationseinrichtung erzeugtes Trägersignal zugeführt werden kann, Modulator-Trägersignal, insbesondere an einem weiteren Eingang des Amplitudenmodulators, Träger-Eingang, und dass der Phasenmodulationswandler eine Logik aufweist, die ausgebildet und/oder eingerichtet ist, um die Phasenlage des Modulator-Trägersignals und/oder des Addierer-Trägersignals bevorzugt dynamisch zu ändern und eine Phasenlage des Modulator-Trägersignals und/oder des Addierer-Trägersignals zu finden, bei der ein Ausgangssignal der Demodulationseinrichtung einen abgeglichenen Wert einnimmt, der den unter dieser Phasenverschiebung maximal erreichbaren Wert darstellt oder sich höchstens um eine vorgegebene Maximalabweichung von dem unter dieser Phasenverschiebung maximal erreichbaren Wert unterscheidet, Addierer-Logik. Die Addierer-Logik ist in bevorzugter Ausgestaltung Bestandteil der Demodulationseinrichtung.

Auch das Modulator-Trägersignal und/oder das Addierer-Trägersignal kann aus dem Ausgangssignal eines insbesondere spannungsgesteuerten Oszillators erzeugt werden, der Bestandteil einer Phasenregelschleife ist.

Die dynamische Änderung der Phasenlage des Modulator-Trägersignals und/oder des Addierer-Trägersignals kann dann z.B. erzielt werden, indem die Phasenlage eines Rückkoppelsignals für den Oszillator, welches ausgangsseitig des Oszillators abgegriffen und dem Oszillator insbesondere eingangsseitig wieder zugeführt wird, bevorzugt dynamisch geändert wird, insbesondere um Schritte von weniger als 40°, bevorzugt um Schritte von weniger als 20°, besonders bevorzugt um Schritte von weniger als 10°.

Zweckmäßiger Weise gilt, dass für die Erzeugung des Referenzsignals ein Oszillator genutzt wird und für die Erzeugung des Modulator-Trägersignals und/oder Addierer-Trägersignals wenigstens ein weiterer Oszillator genutzt wird. Die wenigstens zwei Oszillatoren, die für das Referenzsignal einerseits und das Modulator-Trägersignal und/oder Addierer-Trägersignal andererseits zum Einsatz kommen können, können dabei prinzipiell baugleich sein. Es hat sich als besonders geeignet erwiesen, wenn zur Erzeugung von Modulator- und Addierer-Trägersignal ein gemeinsamer Oszillator genutzt wird.

Auch ein für das Modulator-Trägersignal und/oder das Addierer-Trägersignal genutzter Oszillator kann wenigstens einen phasenvariablen Abgriff und optional wenigstens einen phasenstarren Abgriff aufweisen, wobei der wenigstens eine phasenvariable Abgriff es ermöglicht, die 360° Phasenlage des Oszillators in n Schritte zu unterteilen, wobei n eine natürlich Zahl größer oder gleich 30, insbesondere größer oder gleich 40, bevorzugt größer oder gleich 50, besonders bevorzugt größer oder gleich 100 ist.

Dann kann weiterhin gelten, dass das Modulator-Trägersignal und/oder das Addierer-Trägersignal aus dem wenigstens einen phasenvariablen Abgriff erhalten wird. Der phasenvariablen Abgriff kann dann das Modulator-Trägersignal und/oder das Addierer-Trägersignal ausgeben bzw. von diesem kann das Modulator-Trägersignal und/oder das Addierer-Trägersignal abgegriffen bzw. genommen werden. Die Phasenlage des Referenzsignal kann dann durch entsprechende Ansteuerung bzw. Einstellung des phasenvariablen Abgriffs insbesondere dynamisch und um Schritte von 360°/n geändert werden, bis der gewünschte Wert vorliegt.

Auch im Zusammenhang mit dem Erhalt von Modulator-Trägersignal und/oder Addierer-Trägersignal kann vorgesehen sein, dass der phasenvariable Abgriff mit dem Rückkoppelpfad des Oszillators verbunden ist, so dass ein von dem phasenvariable Abgriff stammendes Signal dem Oszillator als Rückkoppelsignal insbesondere eingangsseitig wieder zugeführt werden kann, und die Phasenlage des von dem phasenvariable Abgriff stammenden Signals dynamisch um Schritte von 360°/n geändert wird. Der wenigstens eine phasenvariable Abgriff kann entsprechend ausgebildet sein.

Der erfindungsgemäße Phasenmodulationswandler, insbesondere dessen Demodulationseinrichtung, kann in Weiterbildung ein Trägersignal-Erzeugungsmodul zur Erzeugung des Modulator-Trägersignals und/oder des Addierer-Trägersignals aufweisen. Das Trägersignal-Erzeugungsmodul kann dann einen insbesondere spannungsgesteuerten Oszillator umfassen, der Bestandteil einer Phasenregelschleife ist, wobei das Modulator-Trägersignal und/oder des Addierer-Trägersignal aus dem Ausgangssignal des Oszillators erzeugt werden kann.

Es kann auch hier gelten, dass der Oszillator wenigstens einen phasenvariablen Abgriff und bevorzugt wenigstens einen phasenstarren Abgriff aufweist, wobei der wenigstens eine phasenvariable Abgriff es ermöglicht, die 360° Phasenlage des Oszillators in n Schritte zu unterteilen, wobei n eine natürlich Zahl größer oder gleich 30, insbesondere größer oder gleich 40, bevorzugt größer oder gleich 50, besonders bevorzugt größer oder gleich 100 ist.

Das Modulator-Trägersignal und/oder das Addierer-Trägersignal kann dann zum Beispiel direkt aus dem phasenvariable Abgriff erhältlich sein. Das Trägersignal-Erzeugungsmodul ist dann entsprechend ausgebildet und/oder eingerichtet.

Alternativ kann der phasenvariable Abgriff mit dem Rückkoppelpfad des Oszillators verbunden sein, so dass ein von dem phasenvariable Abgriff stammendes Signal dem Oszillator als Rückkoppelsignal insbesondere eingangsseitig wieder zugeführt werden kann.

Der Phasenmodulationswandler, zum Beispiel eine Addierer-Logik dieses, kann dann in beiden Fällen ausgebildet und/oder eingerichtet sein, um die Phasenlage des von dem phasenvariable Abgriff des Oszillators des Trägersignal-Erzeugungsmoduls stammenden Signals bevorzugt dynamisch um Schritte von 360°/n zu ändern. Der wenigstens eine phasenvariable Abgriff kann entsprechend ausgebildet sein.

In besonders vorteilhafter Weiterbildung des erfindungsgemäßen Verfahrens wird in einem Schritt S3 in der Regelstellung des Abgleichschalters die Phasenlage des Referenzsignals erneut bevorzugt dynamisch geändert und dabei eine Phasenlage des Referenzsignals gefunden, bei der ein Ausgangssignal der Demodulationseinrichtung einen abgeglichenen Wert einnimmt, welcher entweder null beträgt oder welcher sich höchstens um eine vorgegebene Maximalabweichung von null unterscheidet oder welcher der Hälfte des unter dieser Phasenverschiebung maximal erreichbaren Wertes entspricht oder welcher sich höchstens um eine vorgegebene Maximalabweichung von der Hälfte des unter dieser Phasenverschiebung maximal erreichbaren Wertes unterscheidet.

Der erfindungsgemäße Phasenmodulationswandler ist in vorteilhafter Weiterbildung ausgebildet und/oder eingerichtet, um den Schritt S3 durchzuführen.

Der Schritt S3 wird zweckmäßiger Weise unter bzw. mit derjenigen Phasenlage des Modulator-Trägersignals und/oder des Addierer-Trägersignals durchgeführt, die in Schritt S2 zuvor gefunden wurde.

Es können mit geringem Schaltungsaufwand auch bidirektionale industrielle analoge Eingangskanäle realisiert werden. Sobald es Anforderungen an eine Potentialtrennung der Analogkanäle zur Auswertelogik gibt, kann die Lösung mittels eines erfindungsgemäßen, auch im Betrieb auf einfache Weise abgleichbaren Phasenmodulationswandlers deutlich einfacher realisiert werden als dies bisher gemacht wurde.

Besonders bevorzugt wird für den Schritt S3 - wenn sich der Abgleichschalter in der Regelstellung befindet - eine Eingangsspannung von 0V an den Phasenmodulationswandler angelegt. Der Schritt S3 kann mit anderen Worten insbesondere durchgeführt werden, wenn bzw. während eine Eingangsspannung von 0V an dem Phasenmodulationswandler anliegt. Über diesen Schritt kann dann mit anderen Worten ein Abgleich auf 0V erfolgen, dies je nach Messbereich.

Optional kann in einem Schritt S4 noch eine "Richtungsprobe" durchgeführt werden.

Insbesondere kann vorgesehen sein, dass in einem Schritt S4, wenn sich der Abgleichschalter in der Regelstellung befindet, eine von null verschiedene Eingangsspannung an den Phasenmodulationswandler angelegt und geprüft wird, ob das Ausgangssignals der Demodulationseinrichtung für den Fall einer Eingangsspannung über null einen Wert annimmt, welcher größer ist als der Wert des Ausgangssignals bei 0V Eingangsspannung, und für den Fall einer Eingangsspannung unter null einen Wert annimmt, welcher kleiner ist als der Wert bei 0V Eingangsspannung. Falls dem nicht so ist, wird zweckmäßiger Weise die Phasenlage des Referenzsignals um 180° verschoben. Es ist auch möglich, dass die Phasenlage des Referenzsignals bevorzugt dynamisch in einer Richtung so lange geändert wird, bis erneut derjenige Wert des Ausgangssignals der Demodulationseinrichtung vorliegt, bei dem begonnen wurde. Diese Änderung der Phasenlage des Referenzsignals wird zweckmäßiger Weise durchgeführt, wenn eine Eingangsspannung von 0V an den Phasenmodulationswandler anliegt. Die Änderung bis zur erneuten Findung des Ausgangswertes kann insbesondere erfolgen, wenn keine ausreichend genaue Einstellung von 180° Phasendifferenz realisierbar ist.

Bei einem Phasenmodulationswandler kann es zu einer Eingangsspannung zwei Phasenwinkel geben, welche zum gleichen digitalen Wert führen. Das Referenzsignal, mit dem der Vergleich erfolgt, kann vor oder hinter dem begrenzten Signal liegen, das der Demodulationseinrichtung zugeführt wird. Je nach Reihenfolge von Referenzsignal und begrenztem Signal ergibt sich ein unterschiedliches Verhalten, ob mit zunehmender Eingangsspannung der digitale Wert entsprechend zu - oder abnimmt. Die Reihenfolge von Referenzsignal und begrenztem Signal definiert das Vorzeichen des Gradienten des digitalen Wertes. Mit dem Abgleich gemäß Schritt S4 kann dann praktisch ein Gradient mit richtigem Vorzeichen erzielt werden.

Der erfindungsgemäße Phasenmodulationswandler ist in vorteilhafter Weiterbildung ausgebildet und/oder eingerichtet, um den Schritt S4 durchzuführen.

Als ganz besonders vorteilhaft hat sich erwiesen, wenn im Rahmen des erfindungsgemäßen Verfahrens die Schritte S1, S2 und S3 - und optional S4 - in dieser Reihenfolge durchgeführt werden bzw. der erfindungsgemäße Phasenmodulationswandler zur Durchführung der Schritte S1, S2 und S3 - und optional S4 - in dieser Reihenfolge ausgebildet und/oder eingerichtet ist. Dann kann ein besonders zuverlässiger, umfassender Abgleich des Phasenmodulationswandlers erzielt werden.

Ein Referenzsignal-Erzeugungsmodul und/oder ein Trägersignal-Erzeugungsmodul können Bestandteil einer Takterzeugungseinrichtung des Phasenmodulationswandlers, bevorzugt einer Takterzeugungseinrichtung der Demodulationseinrichtung dieses, sein.

Insbesondere unter Nutzung wenigstens einer Logik kann ein automatisierter Abgleich durchgeführt werden, im Rahmen dessen der Schritt S1, optional der Schritt S2 und ebenfalls optional der Schritt S3 sowie S4 erfolgen. Es kann auch mehr als eine Logik vorgesehen sein bzw. eine gemeinsame Logik kann für die Schritte mehr als ein Modul umfassen. Wie oben angemerkt kann beispielsweise eine Referenz-Logik und eine Addierer-Logik zum Einsatz kommen, um die Phasenlagenänderungen zu realisieren.

Bei dem Amplitudenmodulator mit Trägerunterdrückung kann es sich beispielsweise um einen (digitalen) Schaltermodulator, etwa Doppelgegentaktmodulator, oder auch einen (digitalen) Ringmodulator handeln. Der Schaltermodulator umfasst bevorzugt wenigstens einen insbesondere digitalen Schalter und/oder wenigstens ein mechanisches Relais und/oder wenigstens ein Reed-Relais und/oder wenigstens einen MEMS-Schalter oder ist dadurch gegeben.

Der erfindungsgemäße Phasenmodulationswandler kann Bestandteil einer insbesondere speicherprogrammierbaren Steuerung, insbesondere eines Eingangs bzw. einer Eingangsbaugruppe einer solchen sein. Auch ist es möglich, dass der erfindungsgemäße Phasenmodulationswandler Bestandteil einer Messvorrichtung, etwa eines Oszilloskops oder insbesondere digitalen Multimeters, ist, wobei auch hier bevorzugt gilt, dass er dann Bestandteil eines Eingangs bzw. einer Eingangsbaugruppe ist.

Weitere Vorteile und Merkmale der vorliegenden Erfindung werden anhand der nachfolgenden Beschreibung unter Bezugnahme auf die beiliegende Zeichnung deutlich. Darin zeigt

Figur 1   eine rein schematische Darstellung eines Ausführungsbeispiels einer erfindungsgemäßen Phasenmodulationswandlers;

Figur 2   Takterzeugungseinrichtung, XOR-Modul, Integrator und weitere Komponenten einer alternativ ausgestalteten Demodulationseinrichtung für die Nutzung von vier Abtast-Clocksignalen in vergrößerter, rein schematischer Darstellung,

Figur 3   Takterzeugungseinrichtung, XOR-Modul, Integrator und weitere Komponenten der Demodulationseinrichtung des Phasenmodulationswandlers aus Figur 1 in vergrößerter, rein schematischer Darstellung,

Figur 4   die drei Takterzeugungsblöke der Takterzeugungseinrichtung des Phasenmodulationswandlers aus Figur 1 in vergrößerter Darstellung,

Figur 5   eine schematische Darstellung zur Reihenfolge von $Sig_{RF}$ und $Sig_{BA}$ für den Fall einer unidirektionalen oder bidirektionalen Messung,

Figur 6   drei Zeigerdiagramme betreffend das Modulator-Trägersignal $Sig_{MT}$, das dazu versetzte Addierer-Trägersignal $Sig_{AT}$, das Referenzsignal $Sig_{RF}$, das amplitudenmodulierte Signal $Sig_{AM}$, und das phasenmodulierte Signal $Sig_{PM}$, und

Figur 7   sechs weitere Zeigerdiagramme betreffend das Modulator-Trägersignal $Sig_{MT}$, das dazu versetzte Addierer-Trägersignal $Sig_{AT}$, das Referenzsignal $Sig_{RF}$, das amplitudenmodulierte Signal $Sig_{AM}$, und das phasenmodulierte Signal $Sig_{PM}$.

In den Figuren sind gleiche bzw. ähnliche Elemente und Komponenten mit gleichen Bezugszeichen versehen.

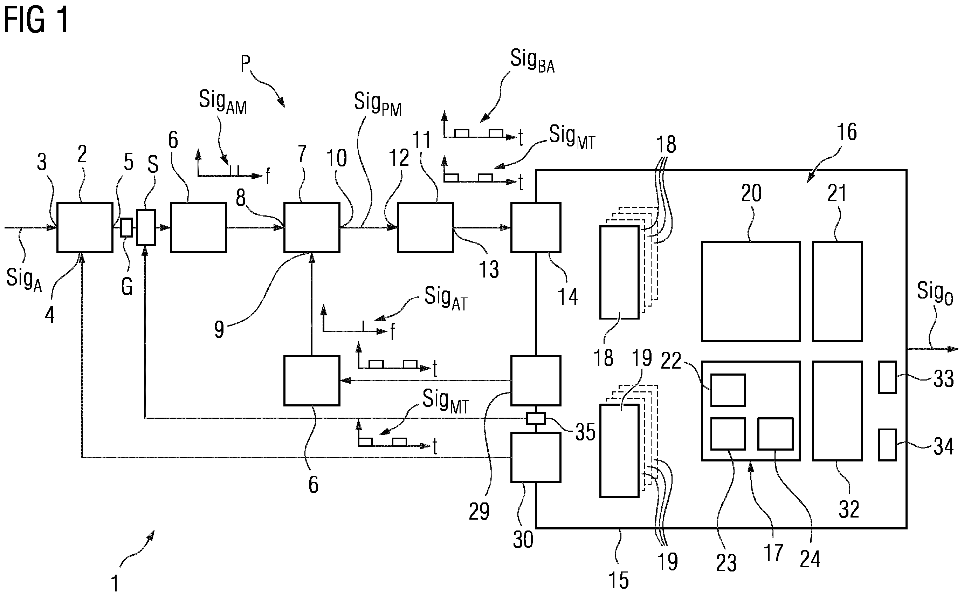

Die Figur 1 zeigt in rein schematischer Blockdarstellung ein Ausführungsbeispiel eines erfindungsgemäßen Phasenmodulationswandlers 1 zur Wandlung eines analogen Eingangssignal $Sig_A$ in ein digitales Ausgangssignal Sigo.

Der Phasenmodulationswandler 1 umfasst einen Amplitudenmodulator 2 mit Trägerunterdrückung, dem ein zu wandelndes analoges Signal Siga, an einen Eingang 3 zugeführt werden kann bzw. zugeführt wird. Der Amplitudenmodulator 2 ist ausgebildet, um aus dem analogen Eingangssignal $Sig_A$, ein trägerloses amplitudenmoduliertes Signal

Sig$_{AM}$ zu erhalten, welches mittels zwei differentieller Leitungen an die nachfolgenden Stufen übertragen wird. Es sei angemerkt, dass in den Figuren nicht beide Leitungen und Eingänge für die differentielle Übertragung separat dargestellt sind, sondern der Übersichtlichkeit halber nur eine(r). Bei dem Amplitudenmodulator 2 kann es sich beispielswiese um einen Schaltermodulator oder einen Ringmodulator handeln. Ein Schaltermodulator kann wenigsten einen insbesondere digitalen Schalter und/oder wenigstens ein mechanisches Relais und/oder wenigstens ein Reed-Relais und/oder wenigstens einen MEMS-Schalter umfassen oder dadurch gegeben sein.

An einem weiteren Eingang 4, der zur Unterscheidung von dem Eingang 3 auch als Träger-Eingang 4 bezeichnet werden kann, wird dem Amplitudenmodulator 2 ein rechteck- oder sinusförmiges Modulator-Trägersignal Sig$_{MT}$ zugeführt, auf dessen Erzeugung weiter unten noch näher eingegangen wird. Aus dem Ausgang 5 des Amplitudenmodulators 2 tritt ein amplitudenmoduliertes Signal Sig$_{AM}$ als differentielles Signal aus.

Das amplitudenmodulierte Signal Sig$_{AM}$ passiert anschließend einen dem Amplitudenmodulator 2 nachgeschalteten analogen Filter 6 und wird einem wiederum nachgeschalteten Addierer 7 des Phasenmodulationswandlers 1 über dessen Eingang 8 zugeführt. An einem weiteren Eingang 9, der als Träger-Eingang bezeichnet werden kann, wird dem Addierer 7 ein weiteres rechteckförmiges oder sinusförmiges Addierer-Trägersignal Sig$_{AT}$ zugeführt, das zu dem sinusförmigen Moulator-Trägersignal Sig$_{MT}$ phasenverschoben ist, insbesondere um 90° phasenverschoben sein soll. Man kann auch sagen, das Addierer-Trägersignal Sig$_{AT}$ ist cosinusförmig. Durch Addition des trägerlosen amplitudenmodulierten Signals Sig$_{AM}$ und des sinusförmigen Addierer-Trägersignals Sig$_{AT}$ wird ein phasenmoduliertes Signal Sig$_{PM}$ mit Störamplitudenmodulation erhalten.

Dem Addierer 7 vorgeschaltet befindet sich ferner ein Abgleichschalter S, auf dessen Ausgestaltung und Verwendung weiter unten noch näher eingegangen wird. Der Abgleichschalter S ist bei dem hier gezeigten Ausführungsbeispiel zwischen dem Amplitudenmodulator 2 und dem Addierer 7 angeordnet, konkret zwischen dem Amplitudenmodulator 2 und dem Filter 6. Es sei angemerkt, dass der Abgleichschalter S prinzipiell auch dem Amplitudenmodulator 2 vorgeschaltet sein könnte, also nicht zwingend zwischen dem Amplitudenmodulator 2 und dem Addierer 7 angeordnet sein muss.

Dem Abgleichschalter S vorgeschaltet befindet sich eine galvanische Trennung G, die hier ein Paar von Koppelkondensatoren umfasst. Diese Art der galvanischen Trennung kann im Falle eines Phasenmodulationswandlers 1 sehr einfach und quasi an beliebiger Stelle in dem Signalpfad P bis zum digitalen Schaltungsteil 15 vorgesehen sein, was einen erheblichen Vorteil des Phasenmodulationswandlers 1 darstellt.

Das Signal Sig$_{PM}$ wird an einem Ausgang 10 des Addierers 7 ausgegeben und einem Begrenzer 11 über dessen Eingang 12 zugeführt. Der Begrenzer 11 ist dazu ausgebildet, eine Störamplitudenmodulation in dem Signal Sig$_{PM}$ zu unterdrücken. Das erhaltene Signal Sig$_{BA}$, das vorliegend auch als begrenztes Signal bezeichnet wird, tritt an dem Ausgang 13 des Begrenzers 11 aus.

Das Signal Sig$_{BA}$ trägt die Modulation nun in zeitlich unterschiedlichen Nulldurchgängen im Vergleich zu dem Addierer-Trägersignal Sig$_{AT}$ bzw. dem unterdrückten Trägersignal Sig$_{MT}$. Dies ist in Figur 1 oben rechts des Begrenzers 11 rein schematisch dargestellt. Zu erkennen sind, jeweils in einem Graphen über der Zeit dargestellt, das Signal Sig$_{BA}$ (oben) und das Signal Sig$_{MT}$ (unten) sowie der zeitliche Versatz Δt. Die Amplitude des Signals Sig$_{BA}$ schwankt zwischen 0 und 1, d.h. man hat ein in der Amplitude digitales Signal erhalten.

Das begrenzte Signal Sig$_{BA}$ wird einem Eingang 14 eines digitalen Schaltungsteils 15 zugeführt, welches der Demodulation des Signals Sig$_{BA}$ und optional weiteren Zwecken dient. Es sei angemerkt, dass, auch wenn in Figur 1 zwischen dem Bregenzer 11 und dem digitalen Schaltungsteil 15 keine weiteren Komponenten gezeigt sind, keineswegs ausgeschlossen ist, dass solche vorhanden sind. Das begrenzte Signal Sig$_{BA}$ kann dem digitalen Schaltungsteil 15 mit anderen Worten direkt oder auch über weitere Komponenten, die auch eine weitere Verarbeitung des Signals bedingen können, zugeführt werden.

Das digitale Schaltungsteil 15 kann wenigstens einen FPGA und/oder ASIC umfassen oder durch wenigstens einen FPGA und/oder ASIC gegeben sein. Bei dem hier dargestellten Ausführungsbeispiel ist das digitale Schaltungsteil durch einen FPGA 15 gegeben.

Auf dem FPGA 15 ist eine Demodulationseinrichtung 16 der Vorrichtung 1 implementiert, mittels derer eine digitale Demodulation des begrenzten Signals Sig$_{BA}$ erfolgen kann. Die Demodulationseinrichtung 16 kann auch als digitaler Demodulator bezeichnet werden.

Im Rahmen der Demodulation erfolgen unter anderem eine Abtastung des Signals Sig$_{BA}$ mittels wenigstens einem Abtast-Clocksignal CLK0-CLK3, ein Vergleich mit einem ebenfalls mit dem wenigstens einen Abtast-Clocksignal abgetasteten Referenzsignal Sig$_{RF}$ und eine Integration des Vergleichs. Auf die Erzeugung des Referenzsignals Sig$_{RF}$ und den Vergleich wird weiter unten noch näher eingegangen.

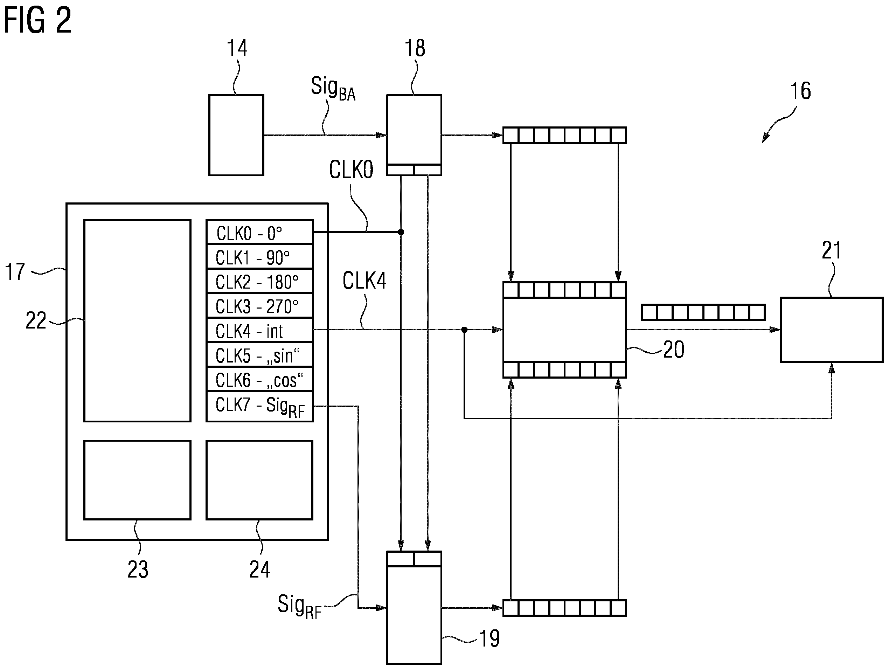

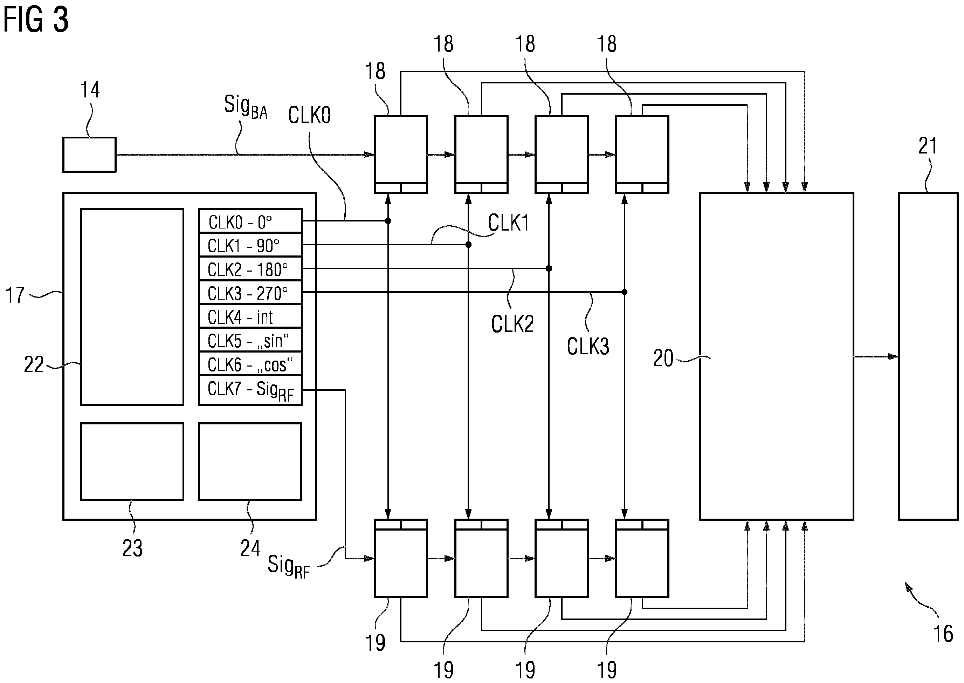

Die Figur 2 erhält eine rein schematische Blockdarstellung zu der digitalen Demodulation unter Verwendung der Demodulationseinrichtung 16 und zwar für den Fall, dass eine Abtastung mit einem Abtast-Clocksignal CLK0 erfolgt. Die Figur 3 zeigt eine alternatives Ausführungsbeispiel zur Nutzung mehrerer Abtast-Clocksignale für die Abtastung, was sich als besonders vorteilhaft erwiesen hat. In Figur 3 ist beispielhaft der Aufbau unter Nutzung von vier Abtast-Clocksignalen CLK0-CLK3 schematisch gezeigt.

Die Demodulationseinrichtung 16 umfasst eine Takterzeugungseinrichtung 17 und wenigstens einen Puffer 18 für das begrenzte Signal $Sig_{BA}$, der bevorzugt durch einen FIFO-Puffer gegeben ist, und vorliegend als Signal-Puffer 18 bezeichnet wird. Es ist ferner wenigstens ein weiterer Puffer 19 für das Referenzsignal $Sig_{RF}$ vorgesehen, der ebenfalls bevorzugt als FIFO-Puffer ausgebildet ist, und zur Unterscheidung gegenüber dem Puffer 18 für das Signal $Sig_{BA}$ als Referenz-Puffer 19 bezeichnet wird. Es sei angemerkt, dass trotz dieser verschiedenen Bezeichnungen der wenigstens eine Signal-Puffer 18 und der wenigstens eine Referenz-Puffer 19 baugleich ausgebildet sein können und vorliegend baugleich ausgebildet sind.

Die Anzahl der Signal-Puffer 18 und die Anzahl der Referenz-Puffer 19 stimmt zweckmäßiger Weise überein und entspricht jeweils der Anzahl der verwendeten Abtast-Clocksignale CLK0-CLK3. Die in Figur 2 gezeigte Demodulationseinrichtung 16 umfasst somit genau einen Signal-Puffer 18 und genau einen Referenz-Puffer 19.

Die Figur 3 zeigt beispielhaft, dass vier Abtast-Clocksignale CLK0-CLK3 zur Abtastung des begrenzten Signals $Sig_{BA}$ und gleichzeitig des Referenzsignals $Sig_{RF}$ genutzt werden können. Die Demodulationseinrichtung 16 aus Figur 3 umfasst entsprechend vier, bevorzugt baugleiche, Signal-Puffer 18 und vier, bevorzugt baugleiche, Referenz-Puffer 19. In Figur 1 sind die Puffer 18, 19 aus Gründen der Übersichtlichkeit hintereinander dargestellt und der vorderste Puffer 18, 19 ist mit durchgezogener Linie gezeichnet, während die dahinterliegenden Puffer 18, 19 mit gestrichelter Linie dargestellt sind, um zu verdeutlichen, dass diese optional zusätzlich vorhanden sein können.

Den Puffern 18, 19 nachgeschaltet und mit den Ausgängen der Puffer 18, 19 verbunden ist ein XOR-Modul 20, welches ein XOR-Gatter umfassen oder durch ein solches gegeben sein kann. Konkret gilt, dass der Ausgang des wenigstens einen Signal-Puffers 18 mit einem Eingang des XOR-Moduls 20 und der Ausgang des wenigstens einen Referenz-Puffers 19 mit dem anderen Eingang des XOR-Moduls 20 verbunden ist, so dass ausgegebene Werte an dieses übergeben und verglichen werden können. Bei dem Ausführungsbeispiel aus Figur 3 sind die Ausgänge aller vier Signal-Puffer 18 mit dem einen Eingang des XOR-Moduls 20 und die Ausgänge aller vier Referenz-Puffer 19 mit dem anderen Eingang des XOR-Moduls 20 verbunden.

Darüber hinaus ist ein dem XOR-Modul 20 nachgeschalteter Integrator 21 vorhanden, mittels dem von dem XOR-Modul 20 ausgegebene Werte integriert werden können.

Bei dem in den Figuren 2 und 3 dargestellten Ausführungsbeispiel umfasst die Takterzeugungseinrichtung 17 der Demodulationseinrichtung 16 insgesamt drei Taktblöcke bzw. Taktmodule 22, 23, 24. Mittels dieser drei Taktblöcke 22, 23, 24 werden insgesamt sieben Signale CLK0-CLK7 erzeugt, auch die für die Abtastung genutzten Abtast-Clocksignale CLK0 (Fig. 2) bzw. CLK0-CLK3 (Fig. 3).

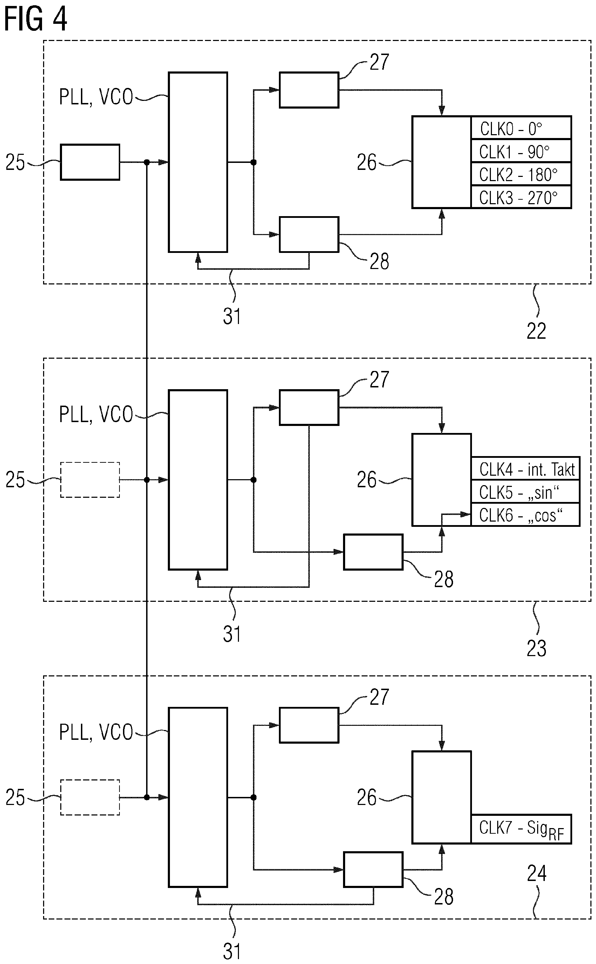

Jedes der Taktmodule 22-24 umfasst dabei eine Phasenregelschleife PLL mit einem spannungsgesteuerten Oszillator VCO. Der interne Aufbau der drei Taktblöcke 22 bis 24 ist - wiederum stark vereinfacht und rein schematisch - in der Figur 4 gezeigt. Hier sind die Phasenregelschleife PLL mit dem spannungsgesteuerten, internen Oszillator VCO des jeweiligen Taktblocks 22-24 vereinfacht als ein Blockelement dargestellt.

Der interne Oszillator VCO jedes Taktmoduls 22-24 wird auf ein externes Referenzsignal von einer externen Taktquelle 25, die beispielsweise durch einen Quarzresonator gegeben sein kann, mit einem entsprechend eingestellten Faktor auf eine höhere innere Frequenz fvco ausgeregelt. Die drei Taktmodule 22-24 können von der gleichen externen Taktquelle 25 versorgt werden, was jedoch nicht zwingend der Fall sein muss.

Die Taktmodule 22-24 können zum Beispiel jeweils durch ein Mixed-Mode Clock-Manager (kurz MMCM) Modul bzw. Block gegeben sein oder ein solches bzw. einen solchen umfassen. Die Hersteller Xilinx bzw. AMD beispielswiese bieten FPGAs mit solchen Modulen bzw. Blöcken an.

Jedes der Taktmodule 22 bis 24 hat mehrere Clockausgänge, die in der Figur 4 durch ein mit der Bezugsziffer 26 versehenes Blockelement angedeutet sind. Jeder Clockausgang kann verschiedene Teiler - und somit Frequenzen - und verschieden fest definierte Phasenlagen annehmen. Alle Takte werden dabei aus fvco abgeleitet. Neben dem die Clockausgänge repräsentierenden Blockelement 26 stehen die von dem jeweiligen Taktblock 22-24 in dem gezeigten Ausführungsbeispiel erzeugten und ausgegebenen Clocksignale CLK0-CLK7. Die entsprechende Nummerierung CLK0 bis CLK7 findet sich auch in den Figuren 2 und 3, dies nebst Pfeilen zu deren konkreter Nutzung, worauf noch eingegangen wird. Jeder Taktblock 22-24 bzw. dessen Oszillator VCO hat sowohl phasenstarre Abgriffe 27 als auch wenigstens einen phasenvariablen Abgriff 28. Der phasenvariable Abgriff 28 ermöglicht eine Unterteilung der Phasenlage in feine Schritte. Bei den hier dargestellten Ausführungsformen kann eine Unterteilung in 56 Schritte erfolgen, mit anderen Worten in Schritte von 360°/n mit n = 56. Die Anzahl von 56 Schritte ist dabei beispielhaft zu verstehen.

Das Taktmodul 22 kommt zum Einsatz, um die schnellen Abtasttakte, mit anderen Worten Abtast-Clocksignale, für die Abtastung sowohl des begrenzten Signals $Sig_{BA}$, als auch des Referenzsignales $Sig_{RF}$ bereitzustellen. Bei dem Beispiel gemäß Figur 2 handelt es sich um das Abtast-Clocksignal CLK0, bei demjenigen gemäß Figur 3 um die Abtast-Clocksignale CLK0-CLK3. Dieses Modul wird als Abtast-Clocksignal-Erzeugungsmodul 22 bezeichnet.

Rein beispielshaft für eine Frequenz der für die Abtastung genutzten schnellen Abtast-Clocksignale CLK0-CLK3, die aus fvco abgeleitet wird, sei 256 MHz genannt, fvco kann beispielsweise 1024 MHz betragen. Selbstverständlich sind auch andere Frequenzen möglich. Zweckmäßiger Weise gilt, dass die Frequenz des (jeweiligen) Abtast-Clocksignals CLK0-CLK3 um wenigstens eine Größenordnung, bevorzugt um zwei Größenordnungen, über der Modulatorfrequenz des Amplitudenmodulators 2 liegt.

Das zweite Taktmodul 23 dient der Erzeugung von langsamen internen Signalen. Dieser erzeugt bei dem dargestellten Ausführungsbeispiel die Clocksignale CLK4, CLK5 und CLK6. CLK4 ist ein langsamerer interner Takt, der vorliegend 32 MHz beträgt, was wiederum beispielhaft zu verstehen ist, und der für die Puffer 18, 19 sowie das XOR-Modul 20 und den Integrator 21 genutzt wird, was in der Figur 2 durch entsprechende Pfeile angedeutet ist. CLK5 entspricht einem Rechteck- oder Sinussignal. CLK6 einem zu dem Rechteck- bzw. Sinussignal versetzten Signal, insbesondere einem Cosinussignal. Das Rechteck- bzw. Sinussignal wird über einen Ausgang 29 des FPGAs 15 in Richtung des Addierers 7 ausgegeben, um $Sig_{AT}$ zu erhalten und dem Eingang 9 des Addierers 7 zuzuführen. Über einen Ausgang 30 des FPGAs 15 wird das Cosinussignal als $Sig_{MT}$ in Richtung des Amplitudenmodulators 2, konkret dessen Eingang 4, ausgegeben. Es sei angemerkt, dass sich zwischen dem Ausgang 29 des FPGAs 15 und dem Eingang 9 des Addierers 7 noch ein analoger Filter 6 befindet. Zwischen dem Ausgang 30 des FPGAs 15 und dem Eingang 4 des Amplitudenmodulators 2 ist eine solcher hingegen nicht eingezeichnet, wenngleich auch nicht ausgeschlossen ist, dass sich hier ebenfalls ein solcher befindet. Das zweite Modul wird, da es der Erzeugung des Modulator-Trägersignals $Sig_{MT}$ und Addierer-Trägersignals $Sig_{AT}$ dient, als Trägersignal-Erzeugungsmodul 23 bezeichnet.

Das dritte Taktmodul 24 dient der Erzeugung von CLK7, was dem Referenzsignal $Sig_{RF}$ entspricht bzw. zu dessen Erzeugung genutzt wird. Es handelt sich um ein rein internes Signal, welches den FPGA 15 nicht verlässt. Dieses Modul wird als Referenzsignal-Erzeugungsmodul 24 bezeichnet.

Die drei Module 22-24 können von ihrem Aufbau her im Wesentlichen übereinstimmen. Es kann Unterschiede geben, worauf weiter unten noch eingegangen wird.

Im Betrieb der Vorrichtung dient im Falle von Fig. 2 der eine Signal-Puffer 18 zur Abtastung des begrenzten Signals $Sig_{BA}$ mit dem schnellen Abtast-Clocksignal CLK0 bzw. dienen im Falle von Fig. 3 die vier Signal-Puffer 18 der Abtastung des begrenzten Signals $Sig_{BA}$ mit den vier fest zueinander phasenversetzten schnellen Abtast-Clocksignalen CLK0-CLK3 sowie der Einsynchronisierung auf die langsamere interne Clockdomäne. Dem (jeweiligen) Signal-Puffer 18 wird eingangsseitig das begrenzte Signal $Sig_{BA}$ zur Abtastung zugeführt. Der (jeweilige) Signal-Puffer 18 erhält sowohl eines der schnellen Abtast-Clocksignale CLK0-CLK3 zur Abtastung, dies von dem Abtast-Clocksignal-Erzeugungsmodul 22, als auch das langsamere interne Clocksignal CLK4, auf welches mittels des (jeweiligen) Signal-Puffers 18 einsynchronisiert wird, dies von dem Trägersignal-Erzeugungsmodul 23. Es sei angemerkt, dass in der Figur 3 zur Nutzung der mehreren Abtast-Clocksignale CLK0-CLK3 und zugehöriger Puffer 18, 19 die Pfeile zu dem langsameren internen Takt CLK4 aus Gründen der Übersichtlichkeit nicht zusätzlich eingezeichnet sind.

Der (jeweilige) Signal-Puffer 18 hat einen Eingang mit einer Bitbreite von 1 und einen Ausgang mit einer Bitbreite von 8. Das Verhältnis der Bitbreiten vom Eingang zum Ausgang des (jeweiligen) Signal-Puffers 18 wird analog zum Verhältnis der Takte CLKi/CLK4, mit i = 0, 1, 2, 3, gewählt oder umgekehrt. Bei dem hier beschriebenen Beispiel gilt die CLKi/CLK4 = 256 MHz/32 MHz = 8, mit i = 0, 1, 2, 3.

Immer, wenn 8 Abtastwerte in einem Signal-Puffer 18 "aufgelaufen" sind, werden diese mehreren Werte von dem Signal-Puffer 18 ausgegeben und zwar an das XOR-Modul 20. Die Ausgabe erfolgt mit dem langsameren Takt von CLK4, also vorliegend 32 MHz. Man kann auch sagen, der (jeweilige) Signal-Puffer 18 liefert als Ausgang das "abgesamplete" digitale begrenzte Signal $Sig_{BA}$ in zeitlich richtiger Reihenfolge.

Für den (jeweiligen) Referenz-Puffer 19 gilt das vorstehende völlig analog mit dem Unterschied, dass diesen nicht das begrenzte Signal $Sig_{BA}$, sondern das Referenzsignal $Sig_{RF}$ zur Abtastung mit dem (jeweiligen) schnellen Abtast- Clocksignal CLK0-CLK3 und zur Einsynchronisierung auf CLK4 zugeführt wird, wie in den Figuren 2 und 3 schematisch durch zugehörige Pfeile angedeutet.

Von dem (jeweiligen) Referenz-Puffer 19 wird somit das "abgesamplete" digitale Referenzsignal erhalten, welches mit gleichem Clocksignal CLK0 bzw. mit gleichen Clocksignalen CLK0-CLK3 eingetaktet ist. Damit passt die zeitliche Reihenfolge zum "abgesampleten" begrenzten $Sig_{BA}$ Signal, das von dem oder den Signal-Puffern 18 erhalten wird.

Bei der Variante gemäß Figur 3 mit den vier Abtast-Clocksignalen CLK0-CLK3 gibt dabei jeder Signal-Puffer 18 einen anderen Teil des Signals aus. Jede CLK-Abtastdomäne liefert einen Datenblock. In der gleichen Domäne wird passend dazu das Referenzsignals $Sig_{RF}$ "abgetastet". Im XOR-Modul 20 ist dann ein Vergleich "Blockweise" möglich.

Zur Erzielung einer erhöhten Auflösung kann im Rahmend der Abtastung in vorteilhafter Ausgestaltung vorgesehen sein, dass die Phasenlage des einen Abtast-Clocksignals CLK0 (Figur 2) bzw. der mehreren Abtast-Clocksignale CLK0-CLK3 (Figur 3), die für die Abtastung des begrenzten Signals $Sig_{BA}$ und des Referenzsignals $Sig_{RF}$ genutzt werden, dynamisch geändert wird. Der Rückkoppelpfad 31 des Abtast-Clocksignal-Erzeugungsmoduls 22 ist hierfür mit dem phasenvariablen Abgriff 28 des Oszillators VCO verbunden.

Es wird kontinuierlich bzw. wiederholend die Phasenlage des über den Rückkoppelpfad 31 dem Oszillator VCO rückgeführten Signals geändert. Dies erfolgt bevorzugt zyklisch beispielsweise alle paar Mikrosekunden, etwa alle 42 Mikrosekunden. Die Verschiebung der Phasenlage erfolgt dabei jeweils um Schritte von 360°/56 und in die gleiche Richtung. Es ist eine Auflösungserhöhungs-Logik 32 vorgesehen (vgl. Figur 1), welche bevorzugt auf dem FPGA 15 implementiert ist, welcher auch die Demodulationseinrichtung 16 umfasst oder bildet, und welche die entsprechende Steuerung für die dynamische Phasenlagenänderung der Abtast-Clocksignale umsetzt. Die Auflösungserhöhungs-Logik 32 kann Bestandteil der Demodulationseinrichtung 16 sein.

Da bei dem Ausführungsbeispiel gemäß Figur 3 die mehreren Abtast-Clocksignale CLKO-CLK3 alle aus dem Ausgangssignal des einen Oszillators VCO des Abtast-Clocksignal-Erzeugungsmoduls 22 erzeugt werden, resultiert die wiederholte Änderung der Phasenlage des Rückkoppelsignals in eine wiederholte Änderung der Phasenlagen aller für die Abtastung genutzter Abtast-Clocksignale CLK0-CLK3 synchron und um gleich große Schritte.

Durch das Stepping des Feedbacksignals über den Rückkoppelpfad 31 ändert sich mit die Phasenlage aller CLK-Ausgänge des Abtast-Clocksignal-Erzeugungsmoduls 22 synchron zu jedem Phasenschritt des Oszillators VCO. Die einzelnen Abtast-Clocksignale CLK0-CLK3 können zusätzlich weiterhin starr um 90° zueinander versetzt sein.

Im beschriebenen Fall entspricht ein Phasenschritt von

$$t_{STEP} = 1/(768MHz*56) = 1/43,008GHz = 23,25ps.$$

Durch die 90° zueinander versetzten 256MHz Abtasttakte CLK0-CLK3 muss nur eine Phasendifferenz von

$$t_{diff} = 1/(256MHz*4) = 976,56ps$$

überbrückt werden, um alle möglichen diskreten Abtastpunkte mittels des feinschrittingen Phasensteppings abzudecken. Im FPGA 15 werden 42 (976,56ps/23,25ps) Perioden der Modulatorfrequenz aufsummiert.

Die rechnerische Auflösung ergibt sich zu

$$log2(90°/360° * 43008MHz / 1MHz) = 13,39 \text{ Bit}$$

ohne die Frequenz des Amplitudenmodulators 2 zu ändern.

Die Datenrate reduziert sich von 1MHz auf 1MHz/42 = 23,8kHz.

Ohne die dynamische Phasenverschiebung ergäbe sich hingegen eine rechnerische Auflösung von

$$log2(90°/360° * 4*256MHz / 1MHz) = 8 \text{ Bit.}$$

Mittels des den Puffern 18, 19 nachgeschalteten XOR-Moduls 20 wird im Anschluss an die schnelle Abtastung und der Einsynchronisierung festgestellt, zu welchen Zeitpunkten das begrenztes Signal $Sig_{BA}$ und das Referenzsignal $Sig_{RF}$ unterschiedlich sind. Die anschließende Integration mittels des Integrators 21 ergibt den gewandelten Wert, der als Sigo von dem FPGA 15 ausgegeben wird (vgl. Fig. 1).

Zweckmäßiger Weise wird jeweils so lange integriert, bis die vorstehend beschriebene dynamische Änderung der Phasenlage der Abtast-Clocksignale CLK0-CLK3 über einen Winkelbereich von 360°/m erfolgte, wobei m der Anzahl der für die Abtastung von dem begrenztem Signal $Sig_{BA}$ genutzten Abtast-Clocksignale entspricht. Die erfindungsgemäße Vorrichtung 1, insbesondere deren Demodulationseinrichtung 16 bzw. ein FPGA 15 der Vorrichtung, kann entsprechend eingerichtet sein.

Bei dem Phasenmodulationswandler 1 können beispielsweise PCB-Laufzeitdifferenzen vorliegen, was zu verfälschten bzw. ungenauen Ausgaben führen kann. Aus diesem Grunde wird wenigstens ein Mal der im Folgenden beschrieben Abgleich des Phasenmodulationswandlers 1 durchgeführt, insbesondere vor dessen erster Inbetriebnahme durch einen Nutzer, etwa ab Werk, und/oder wenigstens ein (weiteres) Mal nach der Inbetriebnahme.

Der Abgleich kann insbesondere auch durchgeführt werden, wenn eine Messung bidirektionaler Eingangsspannungen unter Verwendung des Phasenmodulationswandlers 1 gewünscht ist.

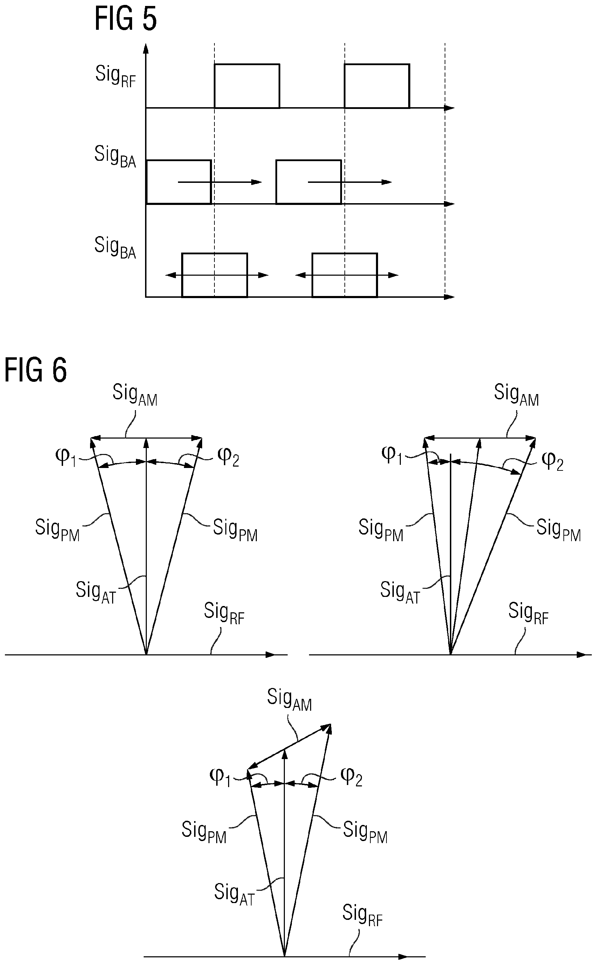

Je nachdem, ob unipolare oder bidirektionale Signale gemessen werden sollen, sollte die Phasen-Nulllage zweckmäßiger Weise eine andere sein (180° vs. 90°). Dies ist rein schematisch in Figur 5 angedeutet. Darin ist oben das Referenzsignal $Sig_{RF}$ gezeigt und darunter zwei Mal das begrenzte Signal $Sig_{BA}$ und zwar mittig in optimaler Ausgangslage für eine unidirektionlae Messung und unten in einer optimalen Ausgangslage für eine bidirektionale Messung.

Weiterhin gilt idealer Weise, dass insbesondere trotz möglicher Laufzeitunterschieden auf der Leiterplatte ein Phasenversatz von 90° zwischen dem Modulator-Trägersignal $Sig_{MT}$ und dem dazu versetzten Addierer-Trägersignal $Sig_{AT}$ möglichst exakt eingehalten wird. Eine Abweichung von den 90° resultiert in einem unterschiedlich großen Phasenhub in die verschiedenen Richtungen. Dies kann am einfachsten anhand von Zeigerdiagrammen nachvollzogen werden, wie sie in Figur 6 gezeigt sind.

Darin zeigt das obere Zeigerdiagramm den Idealfall, bei dem der Phasenversatz dem der addierte Träger für die Phasenmodulation, mit anderen Worten das Addierer-Trägersignal $Sig_{AT}$ und der trägerunterdrückten Amplitudenmodulation $Sig_{AM}$ bzw. dem Signal $Sig_{MT}$ genau 90° beträgt. Daraus resultiert ein gleichmäßiger Phasenhub der Phasenmodulation $Sig_{PM}$ zum Referenzsignal $Sig_{RF}$.

Das mittlere Zeigerdiagramm zeigt den Fall, dass - etwa aufgrund von Laufzeitfehlern auf der Leiterplatte - der Addierer-Träger $Sig_{AT}$ nicht genau 90° zur trägerunterdrückten Amplitudenmodulation $Sig_{AM}$ bzw. dem Signal $Sig_{MT}$ liegt. Der daraus resultierende Phasenhub der Phasenmodulation $Sig_{PM}$ zum Referenzsignal $Sig_{RF}$ ist nicht mehr gleichmäßig.

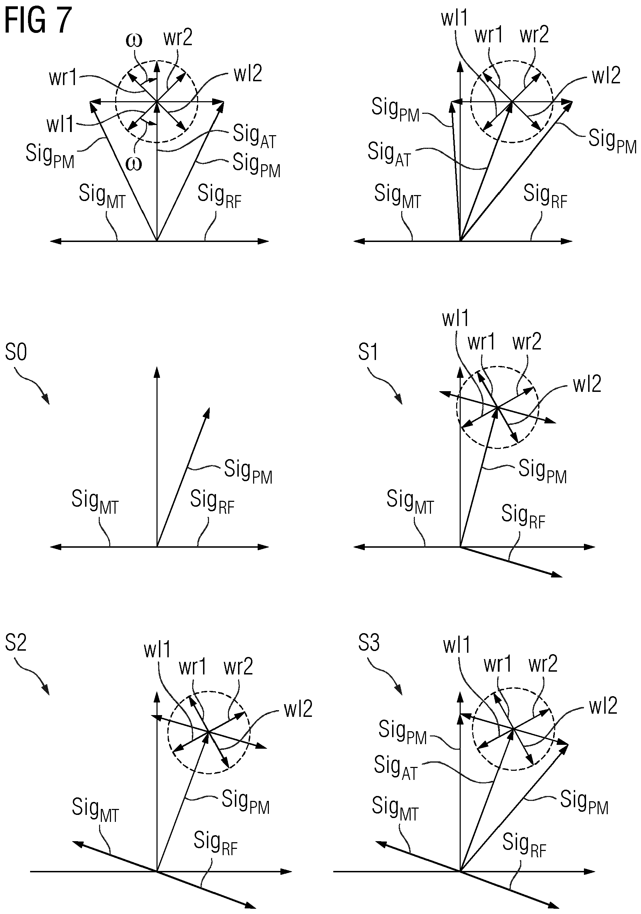

Das untere Zeigerdiagramm zeigt den Fall einer Abweichung von 90° trotz Anpassung des Referenzsignals $Sig_{RF}$. Auch wenn das Referenzsignal $Sig_{RF}$ an den Addierer-Träger $Sig_{AT}$ angepasst wird, ist der resultierende Phasenhub aufgrund der verschobenen trägerunterdrückten Amplitudenmodulation $Sig_{AM}$ bzw. dem Signal $Sig_{MT}$ nicht mehr unbedingt maximal. Daraus kann eine geringere Auflösung des Phasenmodulationswandlers folgen. Auch dies kann über den folgenden Abgleich vermieden werden. Für den Abgleich wird der Abgleichschalter S zunächst in die Abgleichstellung gebracht, sofern er sich nicht bereits in dieser befinden sollte. In Figur 7 ist dieser erste, bei Bedarf erfolgenden Schritt mit S0 markiert. In der Abgleichstellung ist der Eingang 6 des Addierers 7 bzw. sind für den Fall differentieller Signalübertragung die beiden Eingänge 6 des Addierers 7 nicht mehr mit dem Ausgang 5 (bzw. den Ausgängen) des Amplitudenmodulators 2 verbunden, sondern mit der Erde bzw. Masse. Man kann auch sagen, die Amplitudenmodulation $Sig_{AM}$ wird null und die Phasenmodulation $Sig_{PM}$ wird zu $Sig_{AM}$, vorliegend dem Cosinus, der - ungeachtet der Stellung des Abgleichschalters S - weiterhin an dem Eingang 9 des Addierers 7 ankommt.

Um die Eingangsspannung auf 0V zu setzten bieten sich speziell Solid State Relais (SSRs) oder auch einfache MEMS-Schalter an, da damit weiterhin der Vorteil des Phasenmodulationswandlers 1 einer möglichen reinen passiven Schaltung auf der Prozessseite genutzt werden kann. Der Abgleichschalter S kann entsprechend wenigstens ein Solid State Relais und/oder wenigstens einen MEMS-Schalter umfassen oder dadurch gegeben sein. Es kann sich bei diesem insbesondere um einen Wechselschalter handeln..

Anschließend wird in einem Schritt S1 bei Abgleichstellung des Abgleichschalters S die Phasenlage des Referenzsignals $Sig_{RF}$ dynamisch geändert und eine Phasenlage des Referenzsignals $Sig_{RF}$ gefunden, bei der das Ausgangssignal der Demodulationseinrichtung 16, konkret der Digitalwert $Sig_O$, einen abgeglichenen Wert einnimmt, der den unter dieser Phasenverschiebung des Referenzsignals $Sig_{RF}$ maximal erreichbaren Wert darstellt oder sich höchstens um eine vorgegebene Maximalabweichung von dem unter dieser Phasenverschiebung maximal erreichbaren Wert unterscheidet. Man kann auch sagen es startet zunächst ein Verschieben des Referenzsignals $Sig_{RF}$, so dass der Digitalwert Sigo möglichst groß bzw. maximiert wird.

Um die dynamische Phasenverschiebung des Referenzsignals $Sig_{RF}$ zu realisieren, kann der Rückkoppelpfad 31 des Oszillators VCO des Referenz-Erzeugungsmoduls 24 wie in Figur 4 unten erkennbar, mit dem phasenvariablen Abgriff 28 verbunden sein. Alternativ dazu kann der phasenvariable Abgriff 28 auch direkt zur Erzeugung des Referenzsignals $Sig_{RF}$ genutzt werden, dieses Signal mit anderen Worten von diesem bereitgestellt bzw. an diesem abgegriffen werden. Man kann auch sagen, der phasenvariable Abgriff 28 wird in diesem Falle nicht für den Rückkoppelpfad, sondern den "Vorwärtszweig" genutzt. Der Rückkoppelpfad 31 ist dann zweckmäßiger Weise mit dem phasenstarren Abgriff 27 des Referenz-Erzeugungsmoduls 24 verbunden. Eine entsprechende Ausgestaltung ist in der Figur 4 nicht für das Modul 24 dargestellt, jedoch für das Modul 23, auf welches im Folgenden noch näher eingegangen wird.

Es ist ferner eine Referenz-Logik 33 vorgesehen, welche die Verschiebung zur Findung des (möglichst) maximalen Wertes umsetzt. Die Referenz-Logik 33 ist auf dem FPGA 15 der Demodulationseinrichtung 16 implementiert, was ebenfalls beispielhaft zu verstehen ist. Die Verschiebung kann mehrfach bzw. wiederholen jeweils um Schritte von 360°/56 erfolgen, wie es vorstehend bereits im Zusammenhang mit dem Modul 22 beschrieben wurde.

Im nächsten Schritt S2 wird das Referenzsignal nicht weiter verschoben, sondern es wird - unter Beibehaltung der in Schritt S1 gefunden Phasenlage des Referenzsignals $Sig_{RF}$ - nun aktiv $Sig_{MT}$ zu $Sig_{AT}$, vorliegend also die SIN zu COS, verschoben. Dies so lange, bis eine Phasenlage des Modulator-Trägersignals $Sig_M$ und/oder des Addierer-Trägersignals $Sig_{AT}$ gefunden wird, bei der das Ausgangssignal Sigo der Demodulationseinrichtung einen abgeglichenen Wert einnimmt, der den unter dieser Phasenverschiebung maximal erreichbaren Wert darstellt oder sich höchstens um eine vorgegebene Maximalabweichung von dem unter dieser Phasenverschiebung maximal erreichbaren Wert unterscheidet.

Bei dem hier gezeigten Beispiel wird die Phasenlage des Addierer-Trägersignals $Sig_{AT}$ , also des COS, verschoben bzw. geändert. Es versteht sich, dass alternativ natürlich auch das Modulator-Trägersignal $Sig_{MT}$ in seiner Phasenlage geändert werden könnte.

Das Maximum $Sig_O$ unter Änderung der Phasenbeziehung zwischen $Sig_{MT}$ und $Sig_{AT}$ ergibt sich, wenn diese Signale um 90° zueinander versetzt sind. Um die dynamische Phasenverschiebung des Addierer-Trägersignals $Sig_{AT}$ zu realisieren, wird auch für dieses Signal ein phasenvariabler Ausgang 28 genutzt, konkret derjenige des Oszillators VCO des Träger-Erzeugungsmoduls 23 . Man kann auch sagen, das Addierer-Trägersignals $Sig_{AT}$ wird über bzw. von dem phasenvariablen Ausgang 28 ausgegeben bzw. kann an diesem abgegriffen werden. Der phasenvariable Abgriff 28 wird sozusagen für den "Vorwärtszweig" genutzt. Der Vollständigkeit halber sei angemerkt, dass es alternativ prinzipiell auch möglich wäre, dass der phasenvariable Abgriff 28 mit dem Rückkoppelpfad 31 verbunden ist. Dies, wenn für die Erzeugung des Modulator-Trägersignals $Sig_M$ und des Addierer-Trägersignals $Sig_{AT}$ separate Module vorgesehen wären (in den Figuren nicht gezeigt).

Es ist ferner für das Verschieben des Addierer-Trägersignals Sig$_{AT}$ eine Addierer-Logik 34 vorgesehen, welche die Verschiebung unter Nutzung des phasenvariablen Abgriffs 28 zur Findung des (möglichst) maximalen Wertes umsetzt. Die Addierer-Logik 34 ist auf dem FPGA 15 der Demodulationseinrichtung 16 implementiert, was ebenfalls beispielhaft zu verstehen ist. Auch hier kann die Verschiebung bzw. Änderung der Phasenlage prinzipiell so erfolgen, wie oben bereits für Modul 22 und 24 beschrieben.

Anschließend wird in die Regelstellung des Abgleichschalters S gewechselt, eine Eingangsspannung von 0 V an den Phasenmodulationswandler 1 angelegt und in einem Schritt S3 die Phasenlage des Referenzsignals Sig$_{RF}$ erneut bevorzugt dynamisch geändert und dabei eine Phasenlage des Referenzsignals Sig$_{RF}$ gefunden, bei der ein Ausgangssignal Sigo der Demodulationseinrichtung 16 einen abgeglichenen Wert einnimmt, welcher entweder null beträgt oder welcher sich höchstens um eine vorgegebene Maximalabweichung von null unterscheidet oder welcher der Hälfte des unter dieser Phasenverschiebung maximal erreichbaren Wertes entspricht oder welcher sich höchstens um eine vorgegebene Maximalabweichung von der Hälfte des unter dieser Phasenverschiebung maximal erreichbaren Wert unterscheidet. Dies je nachdem, ob eine unidirektionaler (Null) oder bidirektionaler (Max/2) Messung insbesondere einer Eingangsspannung realisiert werden soll. Hierfür kann ebenfalls die Referenz-Logik 33 zum Einsatz kommen.

Optional kann in einem Schritt S4 noch eine "Richtungsprobe" und ggf. Anpassung durchgeführt werden. So kann vorgesehen sein, dass in einem Schritt S4, wenn sich der Abgleichschalter S in der Regelstellung befindet, eine von null verschiedene Eingangsspannung an den Phasenmodulationswandler 1 angelegt und geprüft wird, ob das Ausgangssignal der Demodulationseinrichtung 16 für den Fall einer Eingangsspannung über null einen Wert annimmt, welcher größer ist als der Wert des Ausgangssignals bei 0 V Eingangsspannung, und für den Fall einer Eingangsspannung unter null einen Wert annimmt, welcher kleiner ist als der Wert bei 0 V Eingangsspannung. Falls dem nicht so ist, wird zweckmäßiger Weise die Phasenlage des Referenzsignals Sig$_{RF}$ um 180° verschoben. Sie kann auch bevorzugt dynamisch in einer Richtung so lange geändert werden, bis erneut derjenige Wert des Ausgangssignals der Demodulationseinrichtung 16 vorliegt, bei dem begonnen wurde. Diese Änderung der Phasenlage des Referenzsignals Sig$_{RF}$ wird zweckmäßiger Weise durchgeführt, wenn eine Eingangsspannung von 0 V an dem Phasenmodulationswandler 1 anliegt.

In der Figur 7 sind die vorstehend beschriebenen Schritte bzw. deren Ergebnis, wie bereits angemerkt, anhand von Zeigerdiagrammen visualisiert. Mit Schritt S3 wird ein mit der Eingangsspannung symmetrischer Phasenhub erzielt. In dem Zeigerdiagramm, welches sich oben links, konkret oberhalb desjenigen für Schritt S0 befindet, ist in Figur 7 nochmals der Idealfall und rechts daneben, also über dem Zeigerdiagramm zu Schritt S1, der Fall eines nicht 90° entsprechenden Versatzes von Sig$_{MT}$ zu Sig$_{AT}$. Darin sind wl1, wl2, wr1, wr2 der links- bzw. rechtsdrehende Zeiger zu zwei verschiedenen Zeitpunkten t1 und t2. Weiterhin eingezeichnet sind jeweils die aus dem Parallelogramm wr, wl resultierenden Zeiger.

Durch den dynamischen Abgleich des Offsets sowie der Korrektur der Verzerrung des notwendigen, starren 90° Phasenversatzes zwischen Sig$_{MT}$ zu Sig$_{AT}$, vorliegend SIN und COS, auch zur Laufzeit können nun Fertigungs- und Bauteiltoleranzen ausgeglichen werden. Weiterhin eröffnet sich dadurch die Möglichkeit, mit geringem Schaltungsaufwand bidirektionale industrielle analoge Eingangskanäle zu realisieren. Sobald es Anforderungen an eine Potentialtrennung der Analogkanäle zur Auswertelogik gibt, kann die Lösung mittels eines erfindungsgemäßen, im Betrieb abgleichbaren Phasenmodulationswandlers 1 deutlich einfacher realisiert werden als dies bisher gemacht wurde.

Weiterhin kann die Eigenschaft des Phasenmodulationswandlers 1, dass die Eingangsspannung Sig$_A$ über eine arctan Funktion auf eine Ausgangsspannung Sigo abgebildet wird, hiermit noch besser ausgenutzt werden. Geringe Änderung der Phasendifferenz um die Nulllage bringen einen, im Vergleich zur gleichen Änderung am Rand des Eingangsspannungsbereiches, größeren Signalhub. Das bedeutet, dass das Signal-Rausch-Verhältnis um die Nulllage herum am höchsten ist.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Unabhängig vom grammatikalischen Geschlecht eines bestimmten Begriffes sind Personen mit männlicher, weiblicher oder anderer Geschlechteridentität mit umfasst.

**Patentansprüche**

1. Verfahren zum Abgleichen eines Phasenmodulationswandlers (P), wobei der Phasenmodulationswandler (1) aufweist:

    - einen Amplitudenmodulator (2) mit Trägerunterdrückung, dem ein zu wandelndes Eingangssignal (Sig$_A$) eingangsseitig zugeführt werden kann, um ein trägerloses amplitudenmoduliertes Signal (Sig$_{AM}$) zu erhalten,
    - einen Addierer (7), um zu dem trägerlosen amplitudenmodulierten Signal (Sig$_{AM}$) ein phasenverschobenes, bevorzugt sinusförmiges Addierer-Trägersignal (Sig$_{AT}$) zu addieren und ein phasenmoduliertes Signal (Sig$_{PM}$)

zu erhalten,

- einen Begrenzer (11), dem das phasenmodulierte Signal ($Sig_{PM}$) zugeführt werden und mit dem eine Störamplitudenmodulation in dem phasenmodulierten Signal ($Sig_{PM}$) unterdrückt werden kann, und

- eine Demodulationseinrichtung (16), der das von dem Begrenzer (11) ausgegebene Signal ($Sig_{BA}$) zugeführt und darin demoduliert werden kann, wobei im Rahmen der Demodulation ein Vergleich des von dem Begrenzer ausgegebenen Signals ($Sig_{BA}$) mit einem Referenzsignal ($Sig_{RF}$) erfolgen kann, und wobei in der Demodulationseinrichtung (16) das Addierer-Trägersignal ($Sig_{AT}$) erzeugt werden kann,

- einen dem Addierer (7) vorgeschalteten, insbesondere zwischen dem Amplitudenmodulator (2) und dem Addierer (7) angeordneten Abgleichschalter (S), der zwischen einer Regelstellung, in welcher der Addierer (7) über den Abgleichschalter (S) mit dem Eingang des Phasenmodulationswandler (1) verbunden ist, und wenigstens einer Abgleichstellung, in welcher die Verbindung zwischen dem Addierer (7) und dem Eingang des Phasenmodulationswandler (1) unterbrochen und bevorzugt eine andere Verbindung, insbesondere eine Verbindung des Addierers (7) mit der Erde oder Masse, hergestellt ist, betätigt werden kann,

wobei das Verfahren umfasst, dass in einem Schritt S1 in einer Abgleichstellung des Abgleichschalters (S), insbesondere wenn eine Verbindung mit der Erde oder Masse besteht, die Phasenlage des Referenzsignals bevorzugt dynamisch geändert und eine Phasenlage des Referenzsignals gefunden wird, bei der ein Ausgangssignal der Demodulationseinrichtung einen abgeglichenen Wert einnimmt, der den unter dieser Phasenverschiebung maximal erreichbaren Wert darstellt oder sich höchstens um eine vorgegebene Maximalabweichung von dem unter dieser Phasenverschiebung maximal erreichbaren Wert unterscheidet.

2. Verfahren nach Anspruch 1, **dadurch gekennzeichnet, dass**

das Referenzsignal ($Sig_{RF}$) aus dem Ausgangssignal eines insbesondere spannungsgesteuerten Oszillators (VCO) erzeugt wird, der Bestandteile einer Phasenregelschleife (PLL) ist, und die dynamische Änderung der Phasenlage des Referenzsignals erzielt wird, indem die Phasenlage eines Rückkoppelsignals für den Oszillator (VCO), welches ausgangsseitig des Oszillators (VCO) abgegriffen und dem Oszillator (VCO) insbesondere eingangsseitig wieder zugeführt wird, dynamisch geändert wird, insbesondere um Schritte von weniger als 40°, bevorzugt um Schritte von weniger als 20°, besonders bevorzugt um Schritte von weniger als 10°,

bevorzugt, wobei der Oszillator (VCO) wenigstens einen phasenvariablen Abgriff (28) und wenigstens einen phasenstarren Abgriff (27) aufweist, wobei der wenigstens eine phasenvariable Abgriff (28) es ermöglicht, die 360° Phasenlage des Oszillators (VCO) in n Schritte zu unterteilen, wobei n eine natürlich Zahl größer oder gleich 30, insbesondere größer oder gleich 40, bevorzugt größer oder gleich 50, besonders bevorzugt größer oder gleich 100 ist,

und wobei das Referenzsignals ($Sig_{RF}$) entweder aus dem phasenvariablen Abgriff (28) erhalten wird, oder der phasenvariable Abgriff (28) mit dem Rückkoppelpfad des Oszillators (VCO) verbunden ist, so dass ein von dem phasenvariable Abgriff (28) stammendes Signal dem Oszillator (VCO) als Rückkoppelsignal insbesondere eingangsseitig wieder zugeführt werden kann, und die Phasenlage des von dem phasenvariable Abgriff (28) stammenden Signals dynamisch um Schritte von 360°/n geändert wird.

3. Verfahren nach Anspruch 1 oder 2, **dadurch gekennzeichnet, dass**
dem Amplitudenmodulator (2) für die Trägerunterdrückung ein mittels der Demodulationseinrichtung (16) erzeugtes Trägersignal zugeführt wird, Modulator-Trägersignal ($Sig_{MT}$), insbesondere an einem zweiten Eingang (9) des Amplitudenmodulators (2), und dass in einem Schritt S2 in der Abgleichstellung des Abgleichschalters (S), insbesondere wenn eine Verbindung mit der Erde oder Masse besteht, die Phasenlage des Modulator-Trägersignals ($Sig_{MT}$) und/oder des Addierer-Trägersignals ($Sig_{AT}$) bevorzugt dynamisch geändert und dabei eine Phasenlage des Modulator-Trägersignals ($Sig_{MT}$) und/oder des Addierer-Trägersignals (Si-$g_{AT}$) gefunden wird, bei der ein Ausgangssignal der Demodulationseinrichtung (16) einen abgeglichenen Wert einnimmt, der den unter dieser Phasenverschiebung maximal erreichbaren Wert darstellt oder sich höchstens um eine vorgegebene Maximalabweichung von dem unter dieser Phasenverschiebung maximal erreichbaren Wert unterscheidet.

4. Verfahren nach Anspruch 3, **dadurch gekennzeichnet, dass**

das Modulator-Trägersignal ($Sig_{MT}$) und/oder das Addierer-Trägersigna l($Sig_{AT}$) aus dem Ausgangssignal eines insbesondere spannungsgesteuerten Oszillators (VCO) erzeugt wird, der Bestandteile einer Phasenregelschleife (PLL) ist, und die dynamische Änderung der Phasenlage des Modulator-Trägersignals und/oder des Addierer-Trägersignals erzielt wird, indem die Phasenlage eines Rückkoppelsignals für den Oszillator (VCO), welches ausgangsseitig des Oszillators (VCO) abgegriffen und dem Oszillator (VCO) insbesondere eingangsseitig wieder zugeführt wird, bevorzugt dynamisch geändert wird, insbesondere um Schritte von weniger als 40°, bevorzugt um Schritte von weniger als 20°, besonders bevorzugt um Schritte von weniger als 10°, bevorzugt, wobei der Oszillator (VCO) wenigstens einen phasenvariablen Abgriff (28) und wenigstens einen phasenstarren Abgriff (27) aufweist, wobei der wenigstens eine phasenvariable Abgriff (28) es ermöglicht, die 360° Phasenlage des Oszillators (VCO) in n Schritte zu unterteilen, wobei n eine natürlich Zahl größer oder gleich 30, insbesondere größer oder gleich 40, bevorzugt größer oder gleich 50, besonders bevorzugt größer oder gleich 100 ist, und wobei das Modulator-Trägersignal ($Sig_{MT}$) oder das Addierer-Trägersignal ($Sig_{AT}$) entweder aus dem phasenvariablen Abgriff (28) erhalten wird, oder der phasenvariable Abgriff (28) mit dem Rückkoppelpfad des Oszillators (VCO) verbunden ist, so dass ein von dem phasenvariable Abgriff (28) stammendes Signal dem Oszillator (VCO) als Rückkoppelsignal insbesondere eingangsseitig wieder zugeführt werden kann, und die Phasenlage des von dem phasenvariable Abgriff (28) stammenden Signals dynamisch um Schritte von 360°/n geändert wird.

5. Verfahren nach einem der vorhergehenden Ansprüche, insbesondere nach Anspruch 3 oder 4, **dadurch gekennzeichnet, dass** in einem Schritt S3 in der Regelstellung des Abgleichschalters (S) die Phasenlage des Referenzsignals ($Sig_{RF}$) erneut bevorzugt dynamisch geändert und dabei eine Phasenlage des Referenzsignals ($Sig_{RF}$) gefunden wird, bei der ein Ausgangssignal der Demodulationseinrichtung (16) einen abgeglichenen Wert einnimmt, welcher entweder null beträgt oder welcher sich höchstens um eine vorgegebene Maximalabweichung von null unterscheidet oder welcher der Hälfte des unter dieser Phasenverschiebung maximal erreichbaren Wertes entspricht oder welcher sich höchstens um eine vorgegebene Maximalabweichung von der Hälfte des unter dieser Phasenverschiebung maximal erreichbaren Wert unterscheidet.

6. Verfahren nach Anspruch 5, **dadurch gekennzeichnet, dass** in einem Schritt S4, wenn sich der Abgleichschalter (S) in der Regelstellung befindet, eine von null verschiedene Eingangsspannung an den Phasenmodulationswandler (P) angelegt und geprüft wird, ob das Ausgangssignals der Demodulationseinrichtung (16) für den Fall einer Eingangsspannung über null einen Wert annimmt, welcher größer ist als der Wert des Ausgangssignals bei 0V Eingangsspannung, und für den Fall einer Eingangsspannung unter null einen Wert annimmt, welcher kleiner ist als der Wert bei 0V Eingangsspannung, insbesondere, wobei für den Fall, dass dem nicht so ist, die Phasenlage des Referenzsignals ($Sig_{RF}$) bevorzugt dynamisch in einer Richtung so lange geändert wird, bis eine Phasenlagenänderung von 180° erreicht wurde und/oder erneut derjenige Wert des Ausgangssignals der Demodulationseinrichtung (16) vorliegt, bei dem begonnen wurde, dies insbesondere, wenn eine Eingangsspannung von 0V an dem Phasenmodulationswandler (1) anliegt.

7. Verfahren nach einem der vorhergehenden Ansprüche, **dadurch gekennzeichnet, dass** der Phasenmodulationswandler (1) wenigstens eine galvanische Trennung (G) umfasst, insbesondere, wobei die wenigstens eine galvanische Trennung (G) dem Abgleichschalter (S) vorgeschaltet ist und/oder wenigstens ein Paar von Koppelkondensatoren umfasst.

8. Phasenmodulationswandler (1), umfassend

   - einen Amplitudenmodulator (2) mit Trägerunterdrückung, dem ein zu wandelndes Eingangssignal ($Sig_A$) eingangsseitig zugeführt werden kann, um ein trägerloses amplitudenmoduliertes Signal ($Sig_{AM}$) zu erhalten,
   - einen Addierer (7), um zu dem trägerlosen amplitudenmodulierten Signal ($Sig_{AM}$) ein phasenverschobenes, bevorzugt sinusförmiges Addierer-Trägersignal ($Sig_{AT}$) zu addieren und ein phasenmoduliertes Signal ($Sig_{PM}$) zu erhalten,
   - einen Begrenzer (11), dem das phasenmodulierte Signal (SigPM) zugeführt werden und mit dem eine Störamplitudenmodulation in dem phasenmodulierten Signal ($Sig_{PM}$) unterdrückt werden kann, und
   - eine Demodulationseinrichtung (16), der das von dem Begrenzer (11) ausgegebene Signal ($Sig_{BA}$) zugeführt und darin demoduliert werden kann, wobei im Rahmen der Demodulation ein Vergleich des von dem Begrenzer ausgegebenen Signals ($Sig_{BA}$) mit einem Referenzsignal ($Sig_{RF}$) erfolgen kann, und wobei in der Demodulationseinrichtung (16) das Addierer-Trägersignal ($Sig_{AT}$) erzeugt werden kann, und
   - einen dem Addierer (7) vorgeschalteten, insbesondere zwischen dem Amplitudenmodulator (2) und dem Addierer (7) angeordneten Abgleichschalter (S), der zwischen einer Regelstellung, in welcher der Addierer (7) über den Abgleichschalter (S) mit dem Eingang des Phasenmodulationswandler (1) verbunden ist, und wenigstens einer Abgleichstellung, in welcher die Verbindung zwischen dem und dem Addierer (7) und dem Eingang des Phasenmodulationswandler (1) unterbrochen und bevorzugt eine andere Verbindung, insbesondere eine Verbindung des Addierers (7) mit der Erde oder Masse, hergestellt ist, betätigt werden kann,

wobei der Phasenmodulationswandler (1) ausgebildet und/oder eingerichtet, um für einen Abgleich die Phasenlage des Referenzsignals ($Sig_{RF}$) bevorzugt dynamisch zu ändern und eine Phasenlage des Referenzsignals ($Sig_{RF}$) zu finden, bei der ein Ausgangssignal der Demodulationseinrichtung (16) einen abgeglichenen Wert einnimmt, der den unter dieser Phasenverschiebung maximal erreichbaren Wert darstellt oder sich höchstens um eine vorgegebene Maximalabweichung von dem unter dieser Phasenverschiebung maximal erreichbaren Wert unterscheidet.

9. Phasenmodulationswandler (1) nach Anspruch 8, **dadurch gekennzeichnet, dass** der Phasenmodulationswandler (1) eine Logik aufweist, die ausgebildet und/oder eingerichtet ist, um die Phasenlage des Referenzsignals ($Sig_{RF}$) bevorzugt dynamisch zu ändern und dabei die Phasenlage des Referenzsignals ($Sig_{RF}$) zu finden, bei der das Ausgangssignal der Demodulationseinrichtung (16) den abgeglichenen Wert einnimmt, der den unter dieser Phasenverschiebung maximal erreichbaren Wert darstellt oder sich höchstens um die vorgegebene Maximalabweichung von dem unter dieser Phasenverschiebung maximal erreichbaren Wert unterscheidet, Referenz-Logik (33).

10. Phasenmodulationswandler (1) nach Anspruch 8 oder 9, **dadurch gekennzeichnet, dass** der Phasenmodulationswandler (1), insbesondere die Demodulationseinrichtung (16), ein Referenzsignal-Erzeugungsmodul (24) zur Erzeugung des Referenzsignals ($Sig_{RF}$) aufweist, wobei das Referenzsignal-Erzeugungsmodul (24) einen insbesondere spannungsgesteuerten Oszillators (VCO) umfasst, der Bestandteil einer Phasenregelschleife (PLL) ist, wobei das Referenzsignal aus dem Ausgangssignal des Oszillators (VCO) erzeugt werden kann, bevorzugt, wobei der Oszillator (VCO) wenigstens einen phasenvariablen Abgriff (28) und insbesondere wenigstens einen phasenstarren Abgriff (27) aufweist, wobei der wenigstens eine phasenvariable Abgriff (28) es ermöglicht, die 360° Phasenlage des Oszillators (VCO) in n Schritte zu unterteilen, wobei n eine natürlich Zahl größer oder gleich 30, insbesondere größer oder gleich 40, bevorzugt größer oder gleich 50, besonders bevorzugt größer oder gleich 100 ist, und wobei das Referenzsignal ($Sig_{RF}$) entweder aus dem phasenvariablen Abgriff (28) erhältlich ist, oder der phasenvariable Abgriff (28) mit dem Rückkoppelpfad des Oszillators (VCO) verbunden ist, so dass ein von dem phasenvariablen Abgriff (28) stammendes Signal dem Oszillator (VCO) als Rückkoppelsignal insbesondere eingangsseitig wieder zugeführt werden kann, und der Phasenmodulationswandler (P) ausgebildet und/oder eingerichtet ist, um die Phasenlage des von dem phasenvariable Abgriff (28) des Oszillators (VCO) des Referenzsignal-Erzeugungsmoduls (24) stammenden Signals bevorzugt dynamisch um Schritte von 360°/n zu ändern.

11. Phasenmodulationswandler (1) nach einem der Ansprüche 8 bis 10, **dadurch gekennzeichnet, dass**

der Amplitudenmodulator (2) mit der Demodulationseinrichtung (16) verbunden ist und dem Amplitudenmodulator (2) für die Trägerunterdrückung ein mittels der Demodulationseinrichtung (16) erzeugtes Trägersignal zugeführt werden kann, Modulator-Trägersignal ($Sig_{MT}$), insbesondere an einem zweiten Eingang des Amplitudenmodulators (2), und dass der Phasenmodulationswandler (2) eine Logik aufweist, die ausgebildet und/oder eingerichtet ist, um die Phasenlage des Modulator-Trägersignals ($Sig_{MT}$) und/oder die Phasenlage des Addierer-Trägersignals ($Sig_{AT}$) bevorzugt dynamisch zu ändern und eine Phasenlage des Modulator-Trägersignals ($Sig_{MT}$) und/oder des Addierer-Trägersignals ($Sig_{AT}$) zu finden, bei der ein Ausgangssignal der Demodulationseinrichtung (16) einen abgeglichenen Wert einnimmt, der den unter dieser Phasenverschiebung maximal erreichbaren Wert darstellt oder sich höchstens um eine vorgegebene Maximalabweichung von dem unter dieser Phasenverschiebung maximal erreichbaren Wert unterscheidet, Addierer-Logik,
bevorzugt, wobei der Phasenmodulationswandler (1), insbesondere die Demodulationseinrichtung (16), ein Trägersignal-Erzeugungsmodul (23) zur Erzeugung des Modulator-Trägersignals ($Sig_{MT}$) und/oder des Addierer-Trägersignals ($Sig_{AT}$) aufweist, wobei das Trägersignal-Erzeugungsmodul (23) einen insbesondere spannungsgesteuerten Oszillators (VCO) umfasst, der Bestandteil einer Phasenregelschleife (PLL) ist, wobei das Modulator-Trägersignal und/oder des Addierer-Trägersignal aus dem Ausgangssignal des Oszillators (VCO) erzeugt werden kann,
bevorzugt, wobei der Oszillator (VCO) wenigstens einen phasenvariablen Abgriff (28) und wenigstes einen phasenstarren Abgriff (27) aufweist, wobei der wenigstens eine phasenvariable Abgriff (28) es ermöglicht, die 360° Phasenlage des Oszillators (VCO) in n Schritte zu unterteilen, wobei n eine natürlich Zahl größer oder gleich 30, insbesondere größer oder gleich 40, bevorzugt größer oder gleich 50, besonders bevorzugt größer oder gleich 100 ist,
und wobei das Modulator-Trägersignal ($Sig_{MT}$) oder das Addierer-Trägersignal ($Sig_{AT}$) entweder aus dem phasenvariable Abgriff (28) erhältlich ist, oder der phasenvariable Abgriff (28) mit dem Rückkoppelpfad des Oszillators (VCO) verbunden ist, so dass ein von dem phasenvariable Abgriff (28) stammendes Signal dem Oszillator (VCO) als Rückkoppelsignal insbesondere eingangsseitig wieder zugeführt werden kann, und der Phasenmodulationswandler (P) ausgebildet und/oder eingerichtet ist, um die Phasenlage des von dem phasenvariable Abgriff (28) des Oszillators (VCO) des Trägersignal -Erzeugungsmoduls (23) stammenden Signals bevorzugt dynamisch um Schritte von 360°/n zu ändern.

12. Phasenmodulationswandler (1) nach einem der Ansprüche 8 bis 11, **dadurch gekennzeichnet, dass** der Abgleichschalter (S) als Wechsel-Schalter ausgebildet ist, und/oder dass der Abgleichschalter (S) wenigstens ein mechanisches Relais und/oder wenigstens ein Solid-State-Relais und/oder wenigstens ein Reed-Relais und/oder wenigstens einen MEMS-Schalter umfasst oder dadurch gegeben ist.

13. Phasenmodulationswandler (1) nach einem der Ansprüche 8 bis 12, **dadurch gekennzeichnet, dass** der Phasenmodulationswandler (1) wenigstens eine galvanische Trennung (G) umfasst, insbesondere, wobei die wenigstens eine galvanische Trennung (G) dem Abgleichschalter (S) vorgeschaltet ist und/oder wenigstens ein Paar von Koppelkondensatoren umfasst.

14. Phasenmodulationswandler (1) nach einem der Ansprüche 8 bis 13, **dadurch gekennzeichnet, dass** der Phasenmodulationswandler (1) ausgebildet und/oder eingerichtet ist, um das Verfahren nach Anspruch 5 durchzuführen, insbesondere, wobei der Phasenmodulationswandler (1) ausgebildet und/oder eingerichtet ist, um die Schritte S1, S2 und S3 durchzuführen, bevorzugt, wobei der Phasenmodulationswandler (1) ausgebildet und/oder eingerichtet ist, um das Verfahren nach Anspruch 6 durchzuführen, insbesondere, wobei der Phasenmodulationswandler (1) ausgebildet und/oder eingerichtet ist, um die Schritte S1, S2, S3 und S4 durchzuführen.

FIG 1

FIG 2

EP 4 687 298 A1

# FIG 3

EP 4 687 298 A1

FIG 4

PLL, VCO

25

27

26

| CLK0 – 0° |
| CLK1 – 90° |
| CLK2 – 180° |
| CLK3 – 270° |

28

31

22

PLL, VCO

25

27

26

| CLK4 – int. Takt |
| CLK5 – „sin" |
| CLK6 – „cos" |

28

31

23

PLL, VCO

25

27

26

| CLK7 – Sig$_{RF}$ |

28

24

31

## FIG 5

## FIG 6

# FIG 7

Europäisches
Patentamt

European
Patent Office

Office européen
des brevets

**EUROPÄISCHER RECHERCHENBERICHT**

Nummer der Anmeldung

EP 24 19 2351

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A,D | EP 3 624 334 A1 (SIEMENS AG [DE]) 18. März 2020 (2020-03-18) * Abbildung 1 * * Absatz [0006] - Absatz [0007] * * Absatz [0009] * * Absatz [0013] - Absatz [0016] * ----- | 1-14 | INV. H03M1/12 H04L27/22 H03M1/64 |
| A | CN 114 006 616 A (INST MICROELECTRONICS CAS) 1. Februar 2022 (2022-02-01) * Absatz [0011] * * Absatz [0053] - Absatz [0061] * ----- | 1-14 | |

RECHERCHIERTE
SACHGEBIETE (IPC)

H03M
H04L

Der vorliegende Recherchenbericht wurde für alle Patentansprüche erstellt

| Recherchenort | Abschlußdatum der Recherche | Prüfer |
|---|---|---|
| Den Haag | 13. Januar 2025 | Gimmler-Dumont, C |

EPO FORM 1503 03.82 (P04C03)

**ANHANG ZUM EUROPÄISCHEN RECHERCHENBERICHT
ÜBER DIE EUROPÄISCHE PATENTANMELDUNG NR.** EP 24 19 2351

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

13-01-2025

| Im Recherchenbericht angeführtes Patentdokument | Datum der Veröffentlichung | Mitglied(er) der Patentfamilie | Datum der Veröffentlichung |
|---|---|---|---|
| EP 3624334 A1 | 18-03-2020 | EP 3624334 A1<br>WO 2020058049 A1 | 18-03-2020<br>26-03-2020 |
| CN 114006616 A | 01-02-2022 | KEINE | |

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3624334 A1